# EUROPEAN PATENT APPLICATION

(11) **EP 4 704 216 A1**
(43) Date of publication of application: **04.03.2026**
(21) Application number: 24796244.2
(22) Date of filing: 26.04.2024
(51) Int. Cl.: H01M 10/48, H01M 10/42

(54) **BATTERY MANAGEMENT SYSTEM, BATTERY, VEHICLE, AND BATTERY MANAGEMENT METHOD**

(30) Priority: 28.04.2023 CN 202310489819
(71) Applicant: BYD Company Limited, Shenzhen, Guangdong 518118 (CN)
(72) Inventor: BAO, Wenjing, Shenzhen, Guangdong 518118 (CN); LI, Jie, Shenzhen, Guangdong 518118 (CN); LI, Qifeng, Shenzhen, Guangdong 518118 (CN); YANG, Yun, Shenzhen, Guangdong 518118 (CN)
(74) Representative: Mathys & Squire
(86) International application number: PCT/CN2024/090068
(87) International publication number: WO 2024/222871

(57) **Abstract**

Provided are a battery management system, a battery, a vehicle, and a battery management method. The battery management system includes an analog front-end chip, a high-voltage management chip, a dedicated integrated chip, and a processor chip. The analog front-end chip is connected to a battery group, and is configured to detect status parameter information of at least one battery cell in the battery group. The high-voltage management chip is connected to a power cord of a battery pack, and is configured to detect status parameter information of the battery pack. The battery pack includes a plurality of battery groups. The processor chip is electrically connected to the analog front-end chip through the dedicated integrated chip. The high-voltage management chip is electrically connected to the processor chip through the dedicated integrated chip. The processor chip is configured to manage the battery management system according to the status parameter information of the battery cell and the status parameter information of the battery pack.

## Description

### CROSS-REFERENCE TO RELATED APPLICATIONS

This application claims priority to Chinese Patent Application No. 202310489819.8, filed with the China National Intellectual Property Administration on April 28, 2023 and entitled "BATTERY MANAGEMENT SYSTEM, BATTERY, VEHICLE, AND BATTERY MANAGEMENT METHOD", which is incorporated herein by reference in its entirety.

### TECHNICAL FIELD

This application relates to the field of battery technologies, and in particular, to a battery management system, a battery, a vehicle, and a battery management method.

### BACKGROUND

Currently, battery management systems exhibit poor performance, and cannot estimate and manage battery status in an accurate and timely manner. Consequently, operating efficiency of the battery management systems is affected. In some application scenarios, a conventional battery management system is not applicable at all, further affecting the use and promotion of batteries.

### SUMMARY

This application is intended to resolve at least one of existing technical problems in the prior art. Therefore, according to a first aspect, an embodiment of this application provides a battery management system. The battery management system can improve operating efficiency, safety, and reliability of the battery management system, and is applicable to more application scenarios.

According to a second aspect, an embodiment of this application provides a battery.

According to a third aspect, an embodiment of this application provides a vehicle.

According to a fourth aspect, an embodiment of this application provides a battery management method.

To resolve the foregoing problems, an embodiment of this application according to the first aspect provides a battery management system, including: an analog front-end chip, wherein the analog front-end chip is connected to a battery group, and is configured to detect status parameter information of a battery cell in the battery group, and the battery group includes at least one battery cell; a high-voltage management chip, wherein the high-voltage management chip is connected to a power cord of a battery pack, and is configured to detect status parameter information of the battery pack, and the battery pack includes a plurality of battery groups; a dedicated integrated chip; and a processor chip, wherein the processor chip is electrically connected to the analog front-end chip through the dedicated integrated chip, the high-voltage management chip is electrically connected to the processor chip through the dedicated integrated chip, and the processor chip is configured to manage the battery management system according to the status parameter information of the battery cell and the status parameter information of the battery pack.

According to the battery management system in this embodiment of this application, battery management is implemented based on an architecture of the analog front-end chip, the high-voltage management chip, the dedicated integrated chip, and the processor chip. The processor chip obtains data more quickly and efficiently to improve the operating efficiency of the system, and data transmission paths are more unified to improve data stability. In addition, the battery management system based on this architecture is applicable to more application scenarios.

In some embodiments, the dedicated integrated chip includes: a power supply circuit, wherein the power supply circuit is configured to connect to an external power supply and provide an operating power supply to at least one chip in the battery management system.

In some embodiments, the dedicated integrated chip further includes: a power input port and a power output port, wherein the power supply circuit is connected to the external power supply through the power input port, and the power supply circuit is connected to the processor chip through the power output port, to provide an operating power supply for the processor chip.

In some embodiments, the power supply circuit is connected to the high-voltage management chip through the power output port, to provide an operating power supply for the high-voltage management chip.

In some embodiments, the power supply circuit includes a voltage conversion subcircuit, to provide different operating voltages for the processor chip and the high-voltage management chip.

In some embodiments, the processor chip is further configured to generate power supply configuration information according to a power supply requirement of an internal electric chip of the battery management system, and send the power supply configuration information to the dedicated integrated chip, to manage the battery management system in providing an operating power supply for the internal electric chip; and the dedicated integrated chip further includes: a first digital logic circuit, wherein the first digital logic circuit is electrically connected to the processor chip and the power supply circuit separately, and is configured to control, according to the power supply configuration information, the power supply circuit to provide the operating power supply for the internal electric chip of the battery management system.

In some embodiments, the dedicated integrated chip further includes: a power switch circuit, wherein a first end of the power switch circuit is connected to the power supply circuit, a second end of the power switch circuit is suitable for connecting to an external electric unit, and the power switch circuit is configured to control a power supply status of the external electric unit to be a connected or disconnected state.

The power switch circuit includes: a high-side drive subcircuit, wherein a first end of the high-side drive subcircuit is connected to an output end of the power supply circuit, a second end of the high-side drive subcircuit is suitable for connecting to a power supply side of a power supply loop of the external electric unit, a third end of the high-side drive subcircuit is suitable for connecting to a positive terminal of the external electric unit, and the high-side drive subcircuit is configured to control connection/disconnection between the external electric unit and the power supply side.

In some embodiments, the power switch circuit includes: a low-side drive subcircuit, wherein a first end of the low-side drive subcircuit is connected to an output end of the power supply circuit, a second end of the low-side drive subcircuit is suitable for connecting to a power supply ground side of the power supply loop of the external electric unit, a third end of the low-side drive subcircuit is suitable for connecting to a negative terminal of the external electric unit, and the low-side drive subcircuit is configured to control connection/disconnection between the external electric unit and the power supply ground side.

In some embodiments, the power switch circuit further includes: an enabling switch subcircuit, wherein one end of the enabling switch subcircuit is connected to the high-side drive subcircuit and the low-side drive subcircuit separately, and the other end of the enabling switch subcircuit is connected to the power supply circuit and is configured to control connection/disconnection of the high-side drive subcircuit and the low-side drive subcircuit.

In some embodiments, the processor chip is further configured to generate a power switch channel selection control signal for the high-side drive subcircuit and the low-side drive subcircuit according to an electric power demand of the external electric unit, and send the power switch channel selection control signal to the dedicated integrated chip, to manage the battery management system in connecting or disconnecting power supply for the external electric unit; and the first digital logic circuit is electrically connected to the enabling switch subcircuit, and is configured to control the enabling switch subcircuit according to the power switch channel selection control signal.

In some embodiments, the dedicated integrated chip further includes: an input source detection subcircuit, wherein one end of the input source detection subcircuit is connected to the external power supply through the power input port, and the other end of the input source detection subcircuit is connected to the first digital logic circuit, and is configured to detect the external power supply and transmit power supply detection information of the external power supply to the first digital logic circuit.

In some embodiments, the dedicated integrated chip includes: an input source isolation circuit, wherein the input source isolation circuit is connected to the external power supply and the power supply circuit, and the power supply circuit is connected to the external power supply through the input source isolation circuit.

In some embodiments, the dedicated integrated chip includes: a first daisy-chain serial peripheral interface circuit, wherein the dedicated integrated chip is electrically connected to the analog front-end chip through the first daisy-chain serial peripheral interface circuit.

In some embodiments, the dedicated integrated chip includes:
a first standard serial peripheral interface circuit, wherein one end of the first standard serial peripheral interface circuit is electrically connected to the first daisy-chain serial peripheral interface circuit, and the other end of the first standard serial peripheral interface circuit is electrically connected to the processor chip.

In some embodiments, the first standard serial peripheral interface circuit is configured to send standard serial data to the processor chip or receive data from the processor chip, and transmit the data received from the processor chip as standard serial data to the first daisy-chain serial peripheral interface circuit, and the first daisy-chain serial peripheral interface circuit is configured to convert the standard serial data into corresponding differential data, and send the corresponding differential data to the analog front-end chip; and
the first daisy-chain serial peripheral interface circuit is further configured to receive differential data from the analog front-end chip, and send the differential data received from the analog front-end chip to the first standard serial peripheral interface circuit, and the first standard serial peripheral interface circuit converts the differential data into corresponding standard serial data, and sends the corresponding standard serial data to the processor chip.

In some embodiments, the dedicated integrated chip includes:
a second daisy-chain serial peripheral interface circuit, wherein the dedicated integrated chip is connected to the high-voltage management chip through the second daisy-chain serial peripheral interface circuit.

In some embodiments, the dedicated integrated chip includes:
a second standard serial peripheral interface circuit, wherein one end of the second standard serial peripheral interface circuit is electrically connected to the second daisy-chain serial peripheral interface circuit, and the other end of the second standard serial peripheral interface circuit is electrically connected to the processor chip.

In some embodiments, the second standard serial peripheral interface circuit is configured to receive data from the processor chip, and transmit the data received from the processor chip as standard serial data to the second daisy-chain serial peripheral interface circuit, and the second daisy-chain serial peripheral interface circuit is configured to convert the standard serial data into corresponding differential data, and send the corresponding differential data to the high-voltage management chip; and
the second daisy-chain serial peripheral interface circuit is further configured to receive differential data from the high-voltage management chip, and send the differential data received from the high-voltage management chip to the second standard serial peripheral interface circuit, and the second standard serial peripheral interface circuit converts the differential data into corresponding standard serial data, and sends the corresponding standard serial data to the processor chip.

In some embodiments, the dedicated integrated chip further includes at least one of a first I2C bus interface circuit, a first universal asynchronous receiver/transmitter interface circuit, and a first controller area network bus interface circuit; and the at least one interface circuit is configured for electrical connection between the daisy-chain serial peripheral interface circuit of the dedicated integrated chip and the processor chip, or the at least one interface circuit is configured for communication between the dedicated integrated chip and an external control system.

In some embodiments, the dedicated integrated chip further includes:
a first analog input interface circuit, wherein one end of the first analog input interface circuit is electrically connected to an external sensor, and the other end of the first analog input interface circuit is electrically connected to the first digital logic circuit, and is configured to collect sensor information of the external sensor.

In some embodiments, the dedicated integrated chip further includes:
a first general-purpose input/output interface circuit, wherein one end of the first general-purpose input/output interface circuit is electrically connected to a peripheral circuit, and the other end of the first general-purpose input/output interface circuit is connected to the first digital logic circuit, and is configured to output control information of the first digital logic circuit for the peripheral circuit or collect status information of the peripheral circuit.

In some embodiments, the processor chip is further configured to send configuration information of the dedicated integrated chip to the dedicated integrated chip, and obtain at least one of interface circuit transfer information, safety monitoring information, safety alarm information, and operating status information of the dedicated integrated chip.

In some embodiments, the high-voltage management chip includes:
a signal input port, configured to input the status parameter information of the battery pack; and
a first detection circuit, wherein the first detection circuit is connected to the power cord of the battery pack through the signal input port, and is configured to detect the status parameter information of the battery pack.

In some embodiments, the high-voltage management chip further includes:
a peripheral differential detection circuit, wherein one end of the peripheral differential detection circuit is connected to the power cord of the battery pack, the other end of the peripheral differential detection circuit is connected to the signal input port of the high-voltage management chip, and the first detection circuit detects the status parameter information of the battery pack through the peripheral differential detection circuit.

In some embodiments, the first detection circuit includes: a first voltage detection circuit, wherein the first voltage detection circuit is connected to the signal input port, and is configured to detect voltage information of the battery pack.

In some embodiments, the first detection circuit includes: a first current detection circuit, wherein the first current detection circuit is connected to the signal input port, and is configured to detect current information of the battery pack.

In some embodiments, the processor chip being configured to manage the battery management system according to the status parameter information of the battery cell and the status parameter information of the battery pack includes: the processor chip is configured to estimate a state-of-charge value and/or a state-of-health value of the battery pack according to the voltage information and the current information of the battery pack.

In some embodiments, the high-voltage management chip further includes: a data processing circuit, wherein the data processing circuit is connected to the first voltage detection circuit and the first current detection circuit separately, and is configured to estimate a state-of-charge value and/or a state-of-health value of the battery pack according to the voltage information and the current information of the battery pack.

In some embodiments, the first detection circuit includes: an insulation resistance detection circuit, wherein the insulation resistance detection circuit is configured to detect resistance between the power cord of the battery pack and an insulation ground of a vehicle body; and
the data processing circuit is further configured to determine a status of current leakage of the battery pack according to the resistance.

In some embodiments, the high-voltage management chip further includes:
a first safety diagnosis circuit, wherein the first safety diagnosis circuit is connected to the first detection circuit, and is configured to identify whether the status parameter information of the battery pack is abnormal, and perform safety protection when the status parameter information of the battery pack is abnormal.

In some embodiments, the first safety diagnosis circuit includes:
a first current diagnosis circuit, wherein the first current diagnosis circuit is connected to the first current detection circuit, and is configured to identify whether there is overcurrent in the battery pack according to the current information of the battery pack, and perform overcurrent protection when there is overcurrent in the battery pack.

In some embodiments, the first safety diagnosis circuit includes:
a first voltage diagnosis circuit, wherein the first voltage diagnosis circuit is connected to the first voltage detection circuit, and is configured to identify whether there is overvoltage or undervoltage in the battery pack according to the voltage information of the battery pack, and perform overvoltage or undervoltage protection when there is overvoltage or undervoltage in the battery pack.

In some embodiments, the high-voltage management chip includes:
a second general-purpose input/output interface circuit, wherein the second general-purpose input/output interface circuit is connected to an external sensor or an external load, and is configured to collect information of the external sensor or output a control signal to the external load.

In some embodiments, the high-voltage management chip further includes:
a first temperature detection circuit, wherein the first temperature detection circuit is connected to an external temperature sensor through the second general-purpose input/output interface circuit, to detect temperature information of the high-voltage management chip; and
a first temperature diagnosis circuit, wherein the first temperature diagnosis circuit is connected to the first temperature detection circuit, and is configured to identify whether there is overtemperature in the high-voltage management chip according to the temperature information of the high-voltage management chip, and perform overtemperature protection when there is overtemperature in the high-voltage management chip.

In some embodiments, the processor chip is further configured to send configuration information of the high-voltage management chip to the high-voltage management chip through the dedicated integrated chip, and obtain at least one of detection information, computing result information, safety diagnosis information, and safety alarm information of the high-voltage management chip through the dedicated integrated chip.

In some embodiments, the high-voltage management chip includes:
a third daisy-chain serial peripheral interface circuit, wherein the high-voltage management chip is connected to the second daisy-chain serial peripheral interface circuit of the dedicated integrated chip through the third daisy-chain serial peripheral interface circuit.

In some embodiments, the high-voltage management chip includes at least one of the second standard serial peripheral interface circuit and a second I2C bus interface circuit, and the at least one of the second standard serial peripheral interface circuit and the second I2C bus interface circuit is a standby interface circuit.

In some embodiments, the high-voltage management chip includes: a second controller area network bus interface circuit, wherein the second controller area network bus interface circuit is configured to connect to an external communication bus to obtain external bus information.

In some embodiments, the analog front-end chip includes: a second detection circuit, wherein the second detection circuit is connected to the battery group, and is configured to detect the status parameter information of the battery cell in the battery group.

In some embodiments, the analog front-end chip further includes: a second analog input interface circuit, wherein the second detection circuit is connected to an external detection circuit through the second analog input interface circuit, to detect the status parameter information of the battery cell in the battery group.

In some embodiments, the analog front-end chip further includes: a third general-purpose input/output interface circuit, wherein the third general-purpose input/output interface circuit is connected to an external sensor, and the second detection circuit is connected to the external sensor through the third general-purpose input/output interface circuit, to detect the status parameter information of the battery cell in the battery group.

In some embodiments, the second detection circuit includes: a second voltage detection circuit, wherein the second voltage detection circuit is configured to collect voltage information of the battery cell in the battery group.

In some embodiments, the second detection circuit further includes: a second current detection circuit, wherein the second current detection circuit is configured to collect current information of the battery cell in the battery group.

In some embodiments, the second detection circuit further includes: a stress detection circuit, wherein the stress detection circuit is configured to detect stress information of the battery cell in the battery group.

In some embodiments, the second detection circuit further includes: a second temperature detection circuit, wherein the second temperature detection circuit is configured to detect temperature information of the battery cell in the battery group.

In some embodiments, the front-end analog chip further includes: a second safety diagnosis circuit, wherein the second safety diagnosis circuit is connected to the second detection circuit, and is configured to identify whether the status parameter information of the battery cell is abnormal, and perform safety protection when the status parameter information of the battery cell is abnormal.

In some embodiments, the second safety diagnosis circuit includes: a second voltage diagnosis circuit, wherein the second voltage diagnosis circuit is connected to the second voltage detection circuit, and is configured to identify whether there is overvoltage or undervoltage for a voltage of the battery cell in the battery group, and perform overvoltage or undervoltage protection when there is overvoltage or undervoltage for the voltage of the battery cell.

In some embodiments, the second voltage detection circuit is further configured to detect a voltage of the battery group and voltages of internal components of the analog front-end chip; and the second voltage diagnosis circuit is further configured to identify whether the voltage of the battery group is abnormal and identify whether the voltages of the internal components of the analog front-end chip are abnormal, and perform voltage safety protection when an exception occurs.

In some embodiments, the second safety diagnosis circuit includes: a second current diagnosis circuit, wherein the second current diagnosis circuit is connected to the second current detection circuit, and is configured to identify whether there is overcurrent for a current of the battery cell, and perform overcurrent protection when there is overcurrent for the current of the battery cell.

In some embodiments, the second current detection circuit is further configured to detect a current of the battery group and currents of the internal components of the analog front-end chip; and the second current diagnosis circuit is further configured to diagnose whether the current of the battery group is abnormal and identify whether the currents of the internal components of the analog front-end chip are abnormal, and perform current abnormality safety protection when there is an abnormal current.

In some embodiments, the second safety diagnosis circuit includes: a stress diagnosis circuit, wherein the stress diagnosis circuit is configured to identify whether a stress of the battery cell in the battery group is abnormal, and perform stress abnormality safety protection when the stress is abnormal.

In some embodiments, the second safety diagnosis circuit includes: a second temperature diagnosis circuit, wherein the second temperature diagnosis circuit is connected to the second temperature detection circuit, and is configured to identify whether there is overtemperature for a temperature of the battery cell in the battery group, and perform overtemperature safety protection when there is overtemperature for the temperature of the battery cell.

In some embodiments, the analog front-end chip further includes: a second digital logic circuit, wherein the second digital logic circuit is connected to the second safety diagnosis circuit, and is configured to generate exception information when the status parameter information of the battery cell in the battery group is abnormal, to give an alarm prompt.

In some embodiments, the processor chip is further configured to send configuration information of the analog front-end chip to the analog front-end chip through the dedicated integrated chip, and obtain at least one of detection information, safety diagnosis information, safety alarm information, and computing result information of the analog front-end chip through the dedicated integrated chip.

In some embodiments, the processor chip being configured to manage the battery management system according to the status parameter information of the battery cell and the status parameter information of the battery pack includes: the processor chip is configured to generate power equalization information when it is determined, according to the status parameter information of the battery cell in the battery group, that the power of the battery cell in the battery group is unbalanced, and forward the power equalization information to the corresponding front-end analog chip through the dedicated integrated chip; and the analog front-end chip includes an equalization circuit, wherein the equalization circuit is configured to perform power equalization processing on the battery cell in the battery group according to the power equalization information.

In some embodiments, the processor chip being configured to manage the battery management system according to the status parameter information of the battery cell and the status parameter information of the battery pack includes: the processor chip is configured to determine battery state according to the status parameter information of the battery cell and the status parameter information of the battery pack, and determine, according to the battery state, whether to charge or discharge the battery pack and whether to stop charging or discharging the battery pack.

In some embodiments, the processor chip being configured to manage the battery management system according to the status parameter information of the battery cell and the status parameter information of the battery pack includes: the processor chip is configured to estimate a state-of-charge value of the battery pack according to the status parameter information of the battery cell and/or the status parameter information of the battery pack, obtain a state-of-charge value of the battery pack estimated by the high-voltage management chip, and perform battery state verification according to the state-of-charge value of the battery pack estimated by the processor chip and the state-of-charge value of the battery pack estimated by the high-voltage management chip.

In some embodiments, there are a plurality of analog front-end chips, and the plurality of analog front-end chips are connected in series.

In some embodiments, there are two first daisy-chain serial peripheral interface circuits; each analog front-end chip includes a fourth daisy-chain serial peripheral interface circuit and a fifth daisy-chain serial peripheral interface circuit; and in the plurality of analog front-end chips connected in series, a head-end analog front-end chip is connected to one first daisy-chain serial peripheral interface circuit of the dedicated integrated chip through the fourth daisy-chain serial peripheral interface circuit, and a tail-end analog front-end chip is connected to the other first daisy-chain serial peripheral interface circuit of the dedicated integrated chip through the fifth daisy-chain serial peripheral interface circuit.

In some embodiments, in the plurality of analog front-end chips connected in series, an n^{th} analog front-end chip is connected to the fourth daisy-chain serial peripheral interface circuit of an (n+1)^{th} analog front-end chip through the fifth daisy-chain serial peripheral interface circuit, 1 ≤ n < n+1 ≤ N, and N is a total quantity of the plurality of analog front-end chips connected in series.

In some embodiments, the analog front-end chip includes at least one of a third standard serial peripheral interface circuit and a third I2C bus interface circuit, and the at least one of the third standard serial peripheral interface circuit and the third I2C bus interface circuit is a standby interface circuit.

To achieve the foregoing objectives, an embodiment of this application according to the second aspect provides a battery, including: a battery pack, wherein the battery pack includes a plurality of battery groups, and each battery group includes at least one battery cell; and the battery pack is connected to the battery management system, and each battery group is connected to the battery management system.

Therefore, the battery according to this embodiment of this application is connected to the battery management system provided in the foregoing embodiments. The battery management system runs efficiently and has high data stability and reliability, thereby improving the safety of use of the battery.

To achieve the foregoing objectives, an embodiment of this application according to the third aspect provides a vehicle, including: a battery pack, wherein the battery pack includes a plurality of battery groups, and each battery group includes at least one battery cell; and the battery management system, wherein the battery management system is connected to the battery pack.

Therefore, the vehicle according to this embodiment of this application employs the battery management system in the foregoing embodiments. The battery management system has high operating efficiency, safety and reliability, and is applicable to numerous application scenarios, thereby improving battery management efficiency and safety of the vehicle.

To achieve the foregoing objectives, an embodiment of this application according to the fourth aspect provides a battery management method, which is applicable to the battery management system. The battery management method includes: detecting, by a high-voltage management chip, status parameter information of a battery pack, and detecting, by an analog front-end chip, status parameter information of a battery cell in a battery group, wherein the battery pack includes a plurality of battery groups, and the battery group includes at least one battery cell; forwarding, by a dedicated integrated chip, the status parameter information of the battery pack and the status parameter information of the battery cell in the battery group to a processor chip; and managing, by the processor chip, the battery management system according to the status parameter information of the battery cell and the status parameter information of the battery pack.

In the battery management method according to this embodiment of this application, data exchange between the analog front-end chip and the processor chip and data exchange between the high-voltage management chip and the processor chip are implemented through the dedicated integrated chip, so that data can be effectively and quickly transmitted to improve operating efficiency of the system and data transmission paths are more unified, thereby improving safety and reliability of the system and suiting more application scenarios.

In some embodiments, managing, by the processor chip, the battery management system according to the status parameter information of the battery cell and the status parameter information of the battery pack includes: estimating, by the processor chip, a state-of-charge value and/or a state-of-health value of the battery pack according to voltage information and current information of the battery pack.

In some embodiments, managing, by the processor chip, the battery management system according to the status parameter information of the battery cell and the status parameter information of the battery pack further includes: determining, by the processor chip according to a state of charge of the battery pack, whether to charge or discharge the battery pack and whether to stop charging or discharging the battery pack.

In some embodiments, managing, by the processor chip, the battery management system according to the status parameter information of the battery cell and the status parameter information of the battery pack includes: determining, by the processor chip according to the status parameter information of the battery cell in the battery group, that the power of the battery cell in the battery group is unbalanced, generating power equalization information, and forwarding the power equalization information to the front-end analog chip through the dedicated integrated chip.

In some embodiments, the battery management method further includes: generating, by the processor chip, power supply configuration information according to a power supply requirement of an internal electric chip of the battery management system, and sending the power supply configuration information to the dedicated integrated chip, to manage the battery management system in providing an operating power supply for the internal electric chip.

In some embodiments, the battery management method further includes: generating, by the processor chip, a power switch channel selection control signal according to an electric power demand of an external electric unit, and sending the power switch channel selection control signal to the dedicated integrated chip, to manage the battery management system in connecting or disconnecting power supply for the external electric unit; and controlling, by the dedicated integrated chip according to the power switch channel selection control signal, connection/disconnection between the external electric unit connected to the power supply circuit and a power supply side, or controlling connection/disconnection between the external electric unit and a power supply ground side.

In some embodiments, the battery management method further includes: sending, by the processor chip, configuration information of the dedicated integrated chip to the dedicated integrated chip, and obtaining interface circuit transfer information of the dedicated integrated chip; and obtaining, by the processor chip, at least one of safety monitoring information, safety alarm information, and operating status information of the dedicated integrated chip.

In some embodiments, the battery management method further includes: sending, by the processor chip, configuration information of the high-voltage management chip to the high-voltage management chip through the dedicated integrated chip, and obtaining detection information of the high-voltage management chip through the dedicated integrated chip; and obtaining, by the processor chip, at least one of computing result information, safety diagnosis information, and safety alarm information of the high-voltage management chip through the dedicated integrated chip.

In some embodiments, the battery management method further includes: sending, by the processor chip, configuration information of the analog front-end chip to the analog front-end chip through the dedicated integrated chip, and obtaining detection information of the analog front-end chip through the dedicated integrated chip; and obtaining, by the processor chip, at least one of safety diagnosis information, safety alarm information, and computing result information of the analog front-end chip through the dedicated integrated chip.

In some embodiments, the battery management method further includes: controlling, by the dedicated integrated chip according to the power supply configuration information, a power supply circuit of the dedicated integrated chip to provide an operating power supply for at least one of internal electric chips of the battery management system.

In some embodiments, the status parameter information of the battery pack includes the voltage information and the current information of the battery pack, and the battery management method further includes: estimating, by the high-voltage management chip, a state-of-charge value and/or a state-of-health value of the battery pack according to the voltage information and the current information of the battery pack.

In some embodiments, managing, by the processor chip, the battery management system according to the status parameter information of the battery cell and the status parameter information of the battery pack further includes: obtaining, by the processor chip through the dedicated integrated chip, the state-of-charge value of the battery pack estimated by the high-voltage management chip, and verifying a status of the battery pack according to the state-of-charge value of the battery pack estimated by the processor chip and the state-of-charge value of the battery pack estimated by the high-voltage management chip.

In some embodiments, the status parameter information of the battery pack includes resistance between a power cord of the battery pack and an insulation ground of a vehicle body, and the battery management method further includes: determining, by the high-voltage management chip, a status of current leakage of the battery pack according to the resistance.

In some embodiments, the battery management method further includes: identifying, by the high-voltage management chip, whether the status parameter information of the battery pack is abnormal, and performing safety protection when the status parameter information of the battery pack is abnormal.

In some embodiments, identifying, by the high-voltage management chip, whether the status parameter information of the battery pack is abnormal, and performing safety protection when the status parameter information of the battery pack is abnormal includes at least one of the following: identifying, by the high-voltage management chip according to the current information of the battery pack, whether there is overcurrent in the battery pack, and performing overcurrent protection when there is overcurrent in the battery pack; and identifying, by the high-voltage management chip according to the voltage information of the battery pack, whether there is overvoltage or undervoltage in the battery pack, and performing overvoltage or undervoltage protection when there is overvoltage or undervoltage in the battery pack.

In some embodiments, the battery management method further includes: obtaining, by the high-voltage management chip, temperature information of the high-voltage management chip; and identifying, by the high-voltage management chip according to the temperature information of the high-voltage management chip, whether there is overtemperature in the high-voltage management chip, and performing overtemperature protection when there is overtemperature in the high-voltage management chip.

In some embodiments, the battery management method further includes: identifying, by the analog front-end chip, whether the status parameter information of the battery cell is abnormal, and performing safety protection when the status parameter information of the battery cell is abnormal.

In some embodiments, identifying, by the analog front-end chip, whether the status parameter information of the battery cell is abnormal, and performing safety protection when the status parameter information of the battery cell is abnormal includes at least one of the following: identifying, by the analog front-end chip, whether there is overvoltage or undervoltage for a voltage of the battery cell in the battery group, and performing overvoltage or undervoltage protection when there is overvoltage or undervoltage for the voltage of the battery cell; identifying, by the analog front-end chip, whether there is overcurrent for a current of the battery cell, and performing overcurrent protection when there is overcurrent for the current of the battery cell; identifying, by the analog front-end chip, whether a stress of the battery cell in the battery group is abnormal, and perform safety protection when the stress is abnormal; and identifying, by the analog front-end chip, whether there is overtemperature for a temperature of the battery cell in the battery group, and performing overtemperature safety protection when there is overtemperature for the temperature of the battery cell.

In some embodiments, the battery management method further includes at least one of the following: identifying, by the analog front-end chip, whether a voltage of the battery group is abnormal and identifying whether voltages of internal components of the analog front-end chip are abnormal, and performing voltage safety protection when an exception occurs; and diagnosing, by the analog front-end chip, whether a current of the battery group is abnormal and identifying whether currents of the internal components of the analog front-end chip are abnormal, and performing current protection when there is an abnormal current.

Additional aspects and merits of this application are partly given in the following description, and are partly apparent from the following description, or may be learned from practice of this application.

### BRIEF DESCRIPTION OF DRAWINGS

The foregoing and/or additional aspects and merits of this application become apparent and readily understood from the description of embodiments with reference to the following accompanying drawings.
FIG. 1 is a structural diagram of a battery management system according to an embodiment of this application;
FIG. 2 is a block diagram of a dedicated integrated chip according to an embodiment of this application;
FIG. 3 is a flowchart of high-side and low-side drive configuration according to an embodiment of this application;
FIG. 4 is a diagram of implementing communication connection between a processor chip and an analog front-end chip through interface circuits of a dedicated integrated chip according to an embodiment of this application;
FIG. 5 is a block diagram of a high-voltage management chip according to an embodiment of this application;
FIG. 6 is a block diagram of an analog front-end chip according to an embodiment of this application;
FIG. 7 is a flowchart of data exchange according to an embodiment of this application;
FIG. 8 is a block diagram of a vehicle according to an embodiment of this application;
FIG. 9 is a flowchart of a battery management method according to an embodiment of this application; and
FIG. 10 is a block diagram of a battery according to an embodiment of this application.

### DESCRIPTION OF EMBODIMENTS

Embodiments of this application are described in detail below. The embodiments described with reference to the accompanying drawings are exemplary.

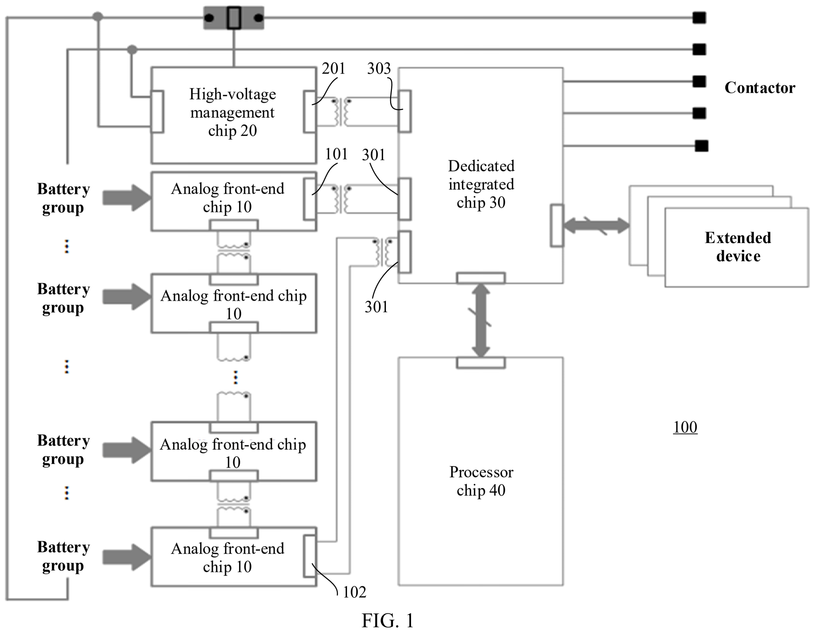

A battery management system provided in an embodiment of this application according to a first aspect is described below with reference to FIG. 1 to FIG. 7.

FIG. 1 is a block diagram of a battery management system according to an embodiment of this application. As shown in FIG. 1, the battery management system 100 according to this embodiment of this application includes analog front-end chips 10, a high-voltage management chip 20, a dedicated integrated chip 30, and a processor chip 40.

The analog front-end chip 10 is connected to a battery group, and is configured to detect status parameter information of a battery cell in the battery group. For example, the battery group includes at least one battery cell. The analog front-end chip 10 monitors status parameter information of the battery group that includes one battery cell or a plurality of battery cells, for example, including but not limited to a current, a voltage, an internal stress and an external stress, or an external temperature of a battery. The battery cell may be a lithium battery, a storage battery, a secondary lithium battery, or a secondary storage battery.

The high-voltage management chip 20 is connected to a power cord of the battery pack, and is configured to detect status parameter information of the battery pack, such as a current and a voltage. The battery pack includes a plurality of battery groups.

As shown in FIG. 1, the battery pack includes a plurality of battery groups, each battery group is correspondingly connected to an analog front-end chip 10, and the analog front-end chip 10 is configured to detect status parameter information of each battery cell in the corresponding battery group. The high-voltage management chip 20 is configured to detect status parameter information of the plurality of battery groups as a whole, namely, the battery pack.

The dedicated integrated chip 30 serves as a bridge chip. The processor chip 40 is connected to the analog front-end chip 10 through the dedicated integrated chip 30, and the processor chip 40 is connected to the high-voltage management chip 20 through the dedicated integrated chip 30. The dedicated integrated chip 30 is configured to forward detection data or generated data of the analog front-end chip 10 to the processor chip 40, and the dedicated integrated chip 30 is configured to forward the detection data and generated data of the high-voltage management chip 20 to the processor chip 40. In addition, the processor chip 40 may send a monitoring parameter to the analog front-end chip 10 and the high-voltage management chip 20 through the dedicated integrated chip 30.

The processor chip 40 may be a processing unit having control, management, and computing capabilities, and is responsible for jobs such as operating status monitoring, data scheduling, and data computing of the entire battery management system 100 and modules that are connected to the battery management system 100.

In this embodiment of this application, the processor chip 40 implements data exchange with the analog front-end chip 10 and the high-voltage management chip 20 through bridge connection with the dedicated integrated chip 30, and is configured to perform data processing and task scheduling according to feedback information, for example, manage the battery management system according to the status parameter information of the battery cell and the status parameter information of the battery pack. The management may include battery pack charging and discharging, battery cell equalization and power estimation, and functional safety monitoring.

The dedicated integrated chip 30 may serve as an extended interface of the processor chip 40, and is equivalent to a bridge chip between the processor chip 40 and the front-end analog chip 10, and a bridge chip between the processor chip 40 and the high-voltage management chip 20. In addition, the dedicated integrated chip 30 can implement data transmission between the high-voltage management chip 20 and the processor chip 40, and data transmission between the analog front-end chip 10 and the processor chip 40. In this mode, data can be efficiently transmitted, operating efficiency of the processor chip 40 is improved, and data transmission paths are more unified, thereby improving safety and reliability of the system and suiting more application scenarios.

In some embodiments, the processor chip 40 may monitor operating statuses of another system and a device that are connected to interfaces of the dedicated integrated chip 30, such as operating statuses and configuration operation parameters of the analog front-end chip 10 and the high-voltage management chip 20, and perform data transmission. The processor chip 40 may perform status configuration on the front-end analog chip 10 and the high-voltage management chip 20 through the dedicated integrated chip 30, and may obtain corresponding data such as collected data or directly obtain processed data, thereby reducing a workload of the processor chip 40.

The processor chip 40 may send configuration information and transfer information to the dedicated integrated chip 30; obtain collected data, stored data, computing result data, and the like that are fed back by the dedicated integrated chip 30; and receive at least one of interface circuit transfer information, safety monitoring information, safety alarm information, and operating status information of the dedicated integrated chip 30. Further, the processor chip 40 may perform task scheduling or monitor the operation of the dedicated integrated chip 30 based on such information.

The processor chip 40 may send configuration information of the analog front-end chip 10, for example, parameters such as system operating time parameters, collected parameters, and data communication parameters of the analog front-end chip 10, to the analog front-end chip 10 through the dedicated integrated chip 30, so that the analog front-end chip 10 performs parameter sampling on the connected battery group, performs safety monitoring on the analog front-end chip 10, and returns a feedback to the processor chip 40 according to configurations. The collected battery parameters include but is not limited to signals such as voltage, current, temperature, and stress of a battery cell. The processor chip 40 may obtain at least one of detection information, safety diagnosis information, safety alarm information, and computing result information of the analog front-end chip 10 through the dedicated integrated chip 30, receive collected data transmitted from the analog front-end chip 10, and estimate a status of each battery cell, including but not limited to computing an SOC value.

The processor chip 40 sends configuration information of the high-voltage management chip 20, for example, system operating time parameters, collected parameters, data communication parameters, and a computing operation of the high-voltage management chip 20, to the high-voltage management chip 20 through the dedicated integrated chip 30, so that the high-voltage management chip 20 performs differential sampling on a total voltage and a total current of all battery cells connected to the high-voltage management chip 20, estimates execution statuses of all battery cells in the high-voltage management chip 20, including but not limited to computing SOC, performs safety monitoring inside the chip, and transmits related data to the processor chip 40 according to configurations. For example, the processor chip 40 may obtain at least one of detection information, computing result information, safety diagnosis information, and safety alarm information of the high-voltage management chip 20 through the dedicated integrated chip 30.

An internal structure of each chip in the battery management system 100 according to this embodiment of this application is described below.

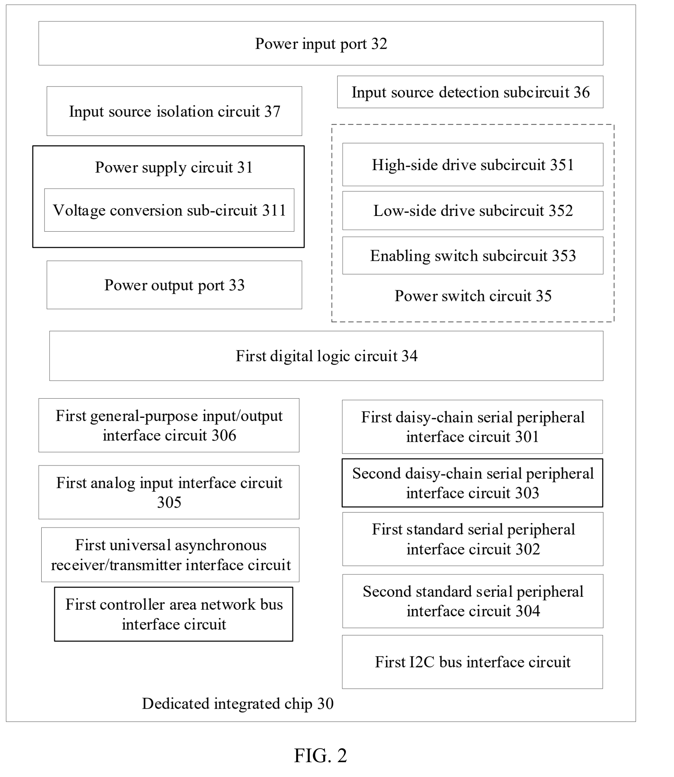

FIG. 2 is a functional block diagram of a dedicated integrated chip 30 according to an embodiment of this application. As shown in FIG. 2, the dedicated integrated chip 30 includes a power supply circuit 31.

The power supply circuit 31 is configured to connect to an external power supply and provide an operating power supply for at least one chip in the battery management system 100. As shown in FIG. 1, an analog front-end chip 10 is connected to a battery group, and the battery group may directly provide a drive power supply. In this embodiment of this application, the dedicated integrated chip 30 is provided with the power supply circuit 31, and the external power supply may be allocated to a chip in the system through the power supply circuit 31, to supply power to the internal electric chip. Therefore, the battery management system 100 does not need to provide an independent drive power supply for each module, thereby improving power supply consistency, reducing design complexity of the entire system, and lowering costs.

As shown in FIG. 2, the dedicated integrated chip 30 further includes a power input port 32 and a power output port 33. The power supply circuit 31 is connected to the external power supply through the power input port 32, and the power supply circuit 31 is connected to the processor chip 40 through the power output port 33, to provide an operating power supply for the processor chip 40.

As shown in FIG. 1, the dedicated integrated chip 30 may obtain an operating power supply from a storage battery of a vehicle through the power input port 32, and convert the operating power supply into a stable power supply, for example, perform voltage stabilization processing through a voltage regulator circuit, and provide the operating power supply for the processor chip 40. Therefore, the processor chip 40 does not need to be provided with an independent drive power supply.

For example, the power supply circuit 31 may convert, through a low dropout linear regulator (low dropout regulator, LDO) module, an input power supply voltage into an operating voltage of an internal module of the chip and a drive voltage of an external unit connected to the power output port 33. In other words, a power supply in a cascaded input manner is converted into a stable voltage through the power input port 32, the power supply circuit 31 (the low dropout linear regulator), and the power output port 33, to provide a power supply voltage for an internal electric chip in the system.

The power supply circuit 31 may also be connected to the high-voltage management chip 20 through the power output port 33, to provide an operating power supply for the high-voltage management chip 20. Therefore, the high-voltage management chip 20 does not need to be provided with an independent drive power supply.

It will be understood that, operating voltages of the electric chips in the battery management system 100 may be different. Therefore, as shown in FIG. 2, the power supply circuit 31 includes a voltage conversion subcircuit 311, one end of the voltage conversion subcircuit 311 is connected to an external power supply through the power input port 32, the other end of the voltage conversion subcircuit 311 is connected to the processor chip 40 and the high-voltage management chip 20, and the voltage conversion subcircuit 311 may provide different operating voltages for the processor chip 40 and the high-voltage management chip 20, to satisfy operating voltage requirements of different electric chips.

In some embodiments, the processor chip 40 may generate power supply configuration information according to a power supply requirement of an internal electric chip of the battery management system 100, and send the power supply configuration information to the dedicated integrated chip 30, to manage the battery management system 100 in providing an operating power supply for the internal electric chip.

As shown in FIG. 2, the dedicated integrated chip 30 further includes a first digital logic circuit 34. The first digital logic circuit 34 is electrically connected to the processor chip 40 and the power supply circuit 31 separately, and is configured to control, according to the power supply configuration information, the power supply circuit 31 to provide the operating power supply for the internal electric chip of the battery management system 100.

For example, after obtaining the power supply from the dedicated integrated chip 30 and starting, the processor chip 40 checks a connection status between the dedicated integrated chip 30 and the processor chip 40 and statuses of devices mounted on the dedicated integrated chip 30. If detecting that the dedicated integrated chip 30 is connected to the analog front-end chip 10 and the high-voltage management chip 20, the processor chip 40 configures and monitors the two chips.

In this way, the power supply circuit 31 of the dedicated integrated chip 30 allocates an external power supply to an internal electric chip of the system, so that internal electric chips do not need to be all provided with independent power supplies, thereby reducing circuit complexity and improving power supply consistency. In addition, the high-voltage management chip 20 has a data processing capability, and the processor chip 40 may directly obtain a computing result, thereby reducing a computing workload of the processor chip 40 and improving data processing efficiency.

In this embodiment of this application, the dedicated integrated chip 30 may further perform power supply monitoring for an electric unit outside the battery management system 100. As shown in FIG. 2, the dedicated integrated chip 30 includes a power switch circuit 35, a first end of the power switch circuit 35 is connected to the power supply circuit 31, and a second end of the power switch circuit 35 is suitable for connecting to an external electric unit. For example, as shown in FIG. 1, an external electric device may be an extended device connected to the dedicated integrated chip 30, or an external high-voltage device connected through a contactor. The power switch circuit 35 is configured to control a power supply status of the external electric unit to be a connected or disconnected state. In other words, the dedicated integrated chip 30 in this embodiment of this application may have functions such as voltage stabilization, voltage conversion, and switching, and may implement a power supply for an internal electric chip in the system, and may control connection/disconnection of power supply for an external electric unit.

Further, as shown in FIG. 2, the power switch circuit 35 includes a high-side drive subcircuit 351. A first end of the high-side drive subcircuit 351 is connected to an output end of the power supply circuit 31. A second end of the high-side drive subcircuit 351 is suitable for connecting to a power supply side of a power supply loop of the external electric unit, and a third end of the high-side drive subcircuit 351 is suitable for connecting to a positive terminal of the external electric unit. The high-side drive subcircuit 351 is configured to control connection/disconnection between the external electric unit and the power supply side of the external electric unit. The high-side drive subcircuit 351 may control an input of the power supply side of the external electric unit, to implement power supply control over the external electric unit.

As shown in FIG. 2, the power switch circuit 35 further includes a low-side drive subcircuit 352. A first end of the low-side drive subcircuit 352 is connected to an output end of the power supply circuit 31, a second end of the low-side drive subcircuit 352 is suitable for connecting to a power supply ground side of the power supply loop of the external electric unit, and a third end of the low-side drive subcircuit 352 is suitable for connecting to a negative terminal of the external electric unit. The low-side drive subcircuit 352 is configured to control connection/disconnection between the external electric unit and the power supply ground side of the external electric unit. In other words, the low-side drive subcircuit 352 may control the connection to the power supply ground side of the external electric unit, to implement power supply control over the external electric unit.

Specifically, in this embodiment, the high-side drive subcircuit 351 and the low-side drive subcircuit 352 each may be a triode, a MOS transistor, or another switching transistor. The high-side drive subcircuit 351 and/or the low-side drive subcircuit 352 may be connected to the external electric unit through a contactor, and a power supply of the external electric unit or a ground of the external electric unit may be controlled to be connected or disconnected according to a power supply requirement of the external electric unit.

As shown in FIG. 2, the power switch circuit 35 further includes an enabling switch subcircuit 353. One end of the enabling switch subcircuit 353 is connected to the high-side drive subcircuit 351 and the low-side drive subcircuit 352. The other end of the enabling switch subcircuit 353 is connected to the power supply circuit 31, and is configured to control connection/disconnection of the high-side drive subcircuit 351 and the low-side drive subcircuit 352. In other words, the high-side drive subcircuit 351 or the low-side drive subcircuit 352 is selectively connected through the enabling switch subcircuit 353, to implement power supply control over the external electric unit.

In this embodiment, the processor chip 40 is further configured to generate a power switch channel selection control signal for the high-side drive subcircuit 351 and the low-side drive subcircuit 352 according to an electric power demand of the external electric unit, and send the power switch channel selection control signal to the dedicated integrated chip 30, to manage the battery management system 100 in connecting or disconnecting power supply for the external electric unit. The first digital logic circuit 34 is electrically connected to the enabling switch subcircuit 353, and is configured to control the enabling switch subcircuit 353 according to the power switch channel selection control signal, so that the enabling switch subcircuit 353 selects to connect the low-side drive subcircuit 352 or selects to connect the high-side drive subcircuit 351 according to the power switch channel selection control signal, thereby implementing power supply control over the external electric unit.

In the foregoing description, the dedicated integrated chip 30 in this embodiment of this application may implement not only power supply control over an electric unit inside the battery management system 100, but also power supply control over an external electric unit.

Specifically, the dedicated integrated chip 30 provides a power supply voltage for the processor chip 40. In this embodiment, the processor chip 40 may select an interface type according to a requirement and an idle state of an interface of the current dedicated integrated chip 30, enable the interface, and select a transmission channel. The processor chip 40 may configure operating parameters of the dedicated integrated chip 30 through an interface to the dedicated integrated chip 30, for example, enabling and selection of the high-side or low-side drive subcircuit, enabling of a drive power supply and channel selection, interface parameters (such as a transmission rate and a transmission period), time-related parameters (such as WDT and internal clock check), and an operating mode (to configure the operating mode that varies depending on a status of the system), and safety monitoring parameters (such as a detection time and a type of a parameter to be detected). The first digital logic circuit 34 may control the power switch circuit 35 and the power supply circuit 31 according to task scheduling information of the processor chip 40 and configuration information, to satisfy power supply requirements of different modules.

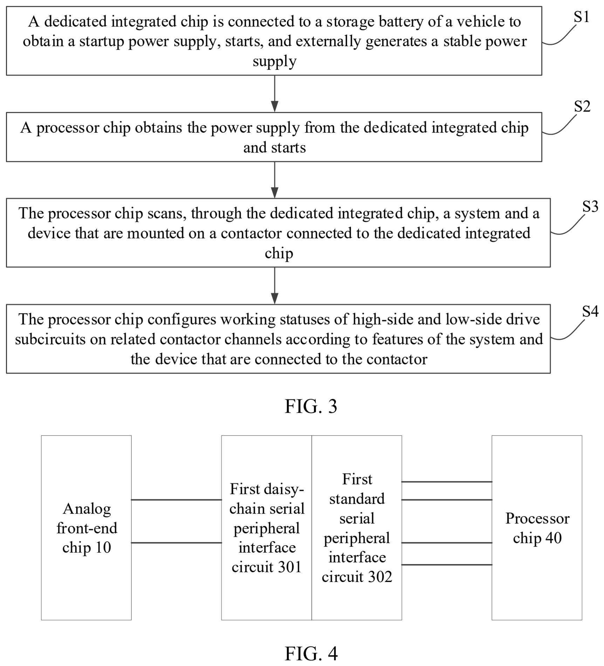

FIG. 3 is a flowchart of configuring a high-side drive subcircuit 351 and a low-side drive subcircuit 352 according to an embodiment of this application. As shown in FIG. 3, the flowchart includes the following steps.

S1: a dedicated integrated chip is connected to a storage battery of a vehicle to obtain a startup power supply, starts, and externally generates a stable power supply.

S2: a processor chip obtains the power supply from the dedicated integrated chip and starts.

S3: the processor chip scans, through the dedicated integrated chip, a system and a device that are mounted on a contactor connected to the dedicated integrated chip.

S4: the processor chip configures operating statuses of high-side and low-side drive subcircuits on related contactor channels according to features of the system and the device that are connected to the contactor.

In some examples, as shown in FIG. 2, the dedicated integrated chip 30 further includes an input source detection subcircuit 36.

One end of the input source detection subcircuit 36 is connected to the external power supply through the power input port 32, and the other end of the input source detection subcircuit 36 is connected to the first digital logic circuit 34, and is configured to detect the external power supply and transmit power supply detection information of the external power supply to the first digital logic circuit 34. The first digital logic circuit 34 may adjust, according to the power supply detection information of the external power supply, power signals input to the high-side drive subcircuit 351 and the low-side drive subcircuit 352, for example, perform voltage boosting/reduction or overvoltage/undervoltage protection; and may perform fault diagnosis on an input source based on the power supply detection information (for example, a detected voltage) of the input external power supply, for example, determine whether there is overvoltage or undervoltage or whether there is a difference.

In other words, the dedicated integrated chip 30 in this embodiment of this application may form a controllable contactor loop based on the power input port 32, the input external power supply, the low-side drive subcircuit 352, the high-side drive subcircuit 351, and the input source detection subcircuit 36. As shown in FIG. 1, the loop embeds an input power supply into the low-side drive subcircuit 352 and the high-side drive subcircuit 351, and extends to a plurality of contactor output ports, so that a connection status of the contactor can be controlled in a programmable manner, and a drive status of the contactor can be quickly configured, to effectively protect a connected device and change an operating status of the device. In addition, the dedicated integrated chip 30 adds a safety protection measure for the power supply output, thereby ensuring normal operation of the loop.

As shown in FIG. 2, the dedicated integrated chip 30 in this embodiment of this application is further provided with an input source isolation circuit 37. The input source isolation circuit 37 is connected to the external power supply and the power supply circuit 31. The power supply circuit 31 is connected to the external power supply through the input source isolation circuit 37. Since internal power of the chip is a low voltage compared with the external power supply, the input source isolation circuit 37 may isolate communication signals or isolate a high-voltage power supply from a low-voltage power supply, to avoid crosstalk of the communication signals and interference between the high-voltage power supply and the low-voltage power supply, thereby improving stability of the power supply provided by the dedicated integrated chip 30.

As shown in FIG. 2, the dedicated integrated chip 30 includes a first daisy-chain serial peripheral interface circuit 301, and the dedicated integrated chip 30 is electrically connected to the analog front-end chip 10 through the first daisy-chain serial peripheral interface circuit 301. Communication between the dedicated integrated chip 30 and the analog front-end chip 10 is implemented through the first daisy-chain serial peripheral interface circuit 301. The daisy-chain serial peripheral interface circuit 301 may play a function of communication isolation, reduce signal crosstalk, and improve communication stability.

As shown in FIG. 2, the dedicated integrated chip 30 further includes a first standard serial peripheral interface circuit 302. One end of the first standard serial peripheral interface circuit 302 is electrically connected to the first daisy-chain serial peripheral interface circuit 301, and the other end of the first standard serial peripheral interface circuit 302 is electrically connected to the processor chip 40.

In other words, isolated data communication between the processor chip 40 and the analog front-end chip 10 is implemented through the first daisy-chain serial peripheral interface circuit 301 and the first standard serial peripheral interface circuit 302 of the dedicated integrated chip 30.

FIG. 4 is a diagram of implementing communication connection between the processor chip 40 and the analog front-end chip 10 through the first daisy-chain serial peripheral interface circuit 301 and the first standard serial peripheral interface circuit 302. As shown in FIG. 4, the dedicated integrated chip 30 implements conversion between standard serial signals of the processor chip 40 and differential signals of the analog front-end chip 10, and transmission of these signals.

Specifically, the first standard serial peripheral interface circuit 302 is configured to send standard serial data such as "0" and "1" to the processor chip 40 or receive data from the processor chip 40, and transmit the data received from the processor chip 40 as standard serial data to the first daisy-chain serial peripheral interface circuit 301. The first daisy-chain serial peripheral interface circuit 301 is configured to convert the standard serial data into corresponding differential data, and send the corresponding differential data to the analog front-end chip 10. The first daisy-chain serial peripheral interface circuit 301 is further configured to receive data from the analog front-end chip 10, and send the data received from the analog front-end chip 10 as corresponding differential data to the first standard serial peripheral interface circuit 302. The first standard serial peripheral interface circuit 302 converts the differential data into corresponding standard serial data, and sends the corresponding standard serial data to the processor chip 40. Therefore, isolated communication between the analog front-end chip 10 and the processor chip 40 is implemented through the dedicated integrated chip 30.

Similarly, in this embodiment, as shown in FIG. 2, the dedicated integrated chip 30 includes a second daisy-chain serial peripheral interface circuit 303, and the dedicated integrated chip 30 is connected to the high-voltage management chip 20 through the second daisy-chain serial peripheral interface circuit 303. In other words, communication between the dedicated integrated chip 30 and the high-voltage management chip 20 is implemented through the second daisy-chain serial peripheral interface circuit 303. The daisy-chain serial peripheral interface circuit may play a function of communication isolation, reduce signal crosstalk, and improve communication stability.

As shown in FIG. 2, the dedicated integrated chip 30 further includes a second standard serial peripheral interface circuit 304. One end of the second standard serial peripheral interface circuit 304 is electrically connected to the second daisy-chain serial peripheral interface circuit 303, and the other end of the second standard serial peripheral interface circuit 304 is electrically connected to the processor chip 40.

In other words, isolated data communication between the processor chip 40 and the high-voltage management chip 20 is implemented through the second daisy-chain serial peripheral interface circuit 303 and the second standard serial peripheral interface circuit 304 of the dedicated integrated chip 30.

Specifically, the second standard serial peripheral interface circuit 304 is configured to receive data from the processor chip 40, and transmit the data received from the processor chip 40 as standard serial data such as "1" and "0" to the second daisy-chain serial peripheral interface circuit 303. The second daisy-chain serial peripheral interface circuit 303 is configured to convert the standard serial data into corresponding differential data, and send the corresponding differential data to the high-voltage management chip 20. The second daisy-chain serial peripheral interface circuit 303 is further configured to receive data from the high-voltage management chip 20, and send the data received from the high-voltage management chip 20 as corresponding differential data to the second standard serial peripheral interface circuit 304. The second standard serial peripheral interface circuit 304 converts the differential data into corresponding standard serial data, and sends the corresponding standard serial data to the processor chip 40. Therefore, isolated communication between the high-voltage management chip 20 and the processor chip 40 is implemented through the dedicated integrated chip 30.

In addition, as shown in FIG. 2, the dedicated integrated chip 30 further includes a first analog input interface circuit 305. One end of the first analog input interface circuit 305 is electrically connected to an external sensor, and the other end of the first analog input interface circuit 305 is electrically connected to the first digital logic circuit 34, and is configured to collect sensor information of the external sensor. For example, the external sensor may include a voltage sensor, a current sensor, or the like. An analog detection signal such as a circuit signal or a voltage signal may be received through the first analog input interface circuit 305.

The dedicated integrated chip 30 further includes a first general-purpose input/output interface circuit 306. One end of the first general-purpose input/output interface circuit 306 is connected to a peripheral circuit such as an LED loop. The other end of the first general-purpose input/output interface circuit 306 is connected to the first digital logic circuit 34, and is configured to output control information of the first digital logic circuit 34 for the peripheral circuit or collect status information of the peripheral circuit.

The dedicated integrated chip 30 further includes at least one of a first I2C bus interface circuit, a first universal asynchronous receiver/transmitter interface circuit, and a first controller area network bus interface circuit. The at least one interface circuit is configured for electrical connection between the daisy-chain serial peripheral interface circuit of the dedicated integrated chip 30 and the processor chip 40, or the at least one interface circuit is configured for communication between the dedicated integrated chip 30 and an external control system, thereby facilitating system expansion.

In conclusion, the dedicated integrated chip 30 in this embodiment of this application not only integrates functions of wide-voltage input, a plurality of ports, and a plurality of power supplies for output, but also provides a stable power supply required by a peripheral system. In addition, the dedicated integrated chip 30 integrates a plurality of interface circuits, to exchange data with a control system of another system and convert interface data in different interface data formats, thereby providing required interface data for a less-intelligent system and supporting function expansion of the dedicated integrated chip 30. Furthermore, the dedicated integrated chip 30 may be organized into a specific power supply network for a power supply system including, for example, internal electric units and external electric units of the battery management system 100, to implement multi-party monitoring and improve consistency and reliability of the entire battery management system 100. A linear and stable power supply may be provided, through the power output port 33 connected to the power supply circuit 31, for a system that is not directly connected to the battery. In addition, controllable contactor output may be implemented through high-side drive and low-side drive, to control power supply for the external electric unit.

An internal structure of the high-voltage management chip 20 in this embodiment of this application is described below.

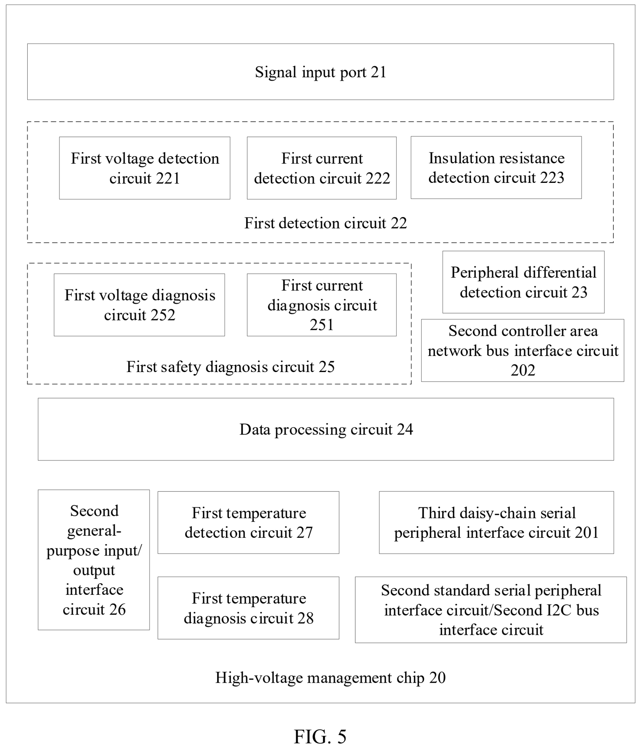

FIG. 5 is a diagram of an internal structure of a high-voltage management chip 20 according to an embodiment of this application. As shown in FIG. 5, the high-voltage management chip 20 includes a signal input port 21 and a first detection circuit 22.

The signal input port 21 is configured to input the status parameter information of the battery pack. The first detection circuit 22 is connected to the power cord of the battery pack through the signal input port 21, and is configured to detect the status parameter information of the battery pack, such as a voltage signal and a current signal, to implement detection of the status parameter information of the battery pack. In this way, the high-voltage management chip 20 may perform battery status estimation and the like based on the detection information, and may also send the information to the processor chip 40 through the dedicated integrated chip 30, so that the processor chip 40 performs management, task scheduling, and the like based on such information.

The high-voltage management chip 20 includes a peripheral differential detection circuit 23, one end of the peripheral differential detection circuit 23 is connected to the power cord of the battery pack, and the other end of the peripheral differential detection circuit 23 is connected to the signal input port 21 of the high-voltage management chip 20. The first detection circuit 22 detects the status parameter information of the battery pack through the peripheral differential detection circuit 23.

Specifically, the peripheral differential detection circuit 23 may detect the status parameter information of the battery pack, such as a voltage differential signal and a current differential signal, and send the detected status parameter information of the battery pack to the first detection circuit 22 of the high-voltage management chip 20 through the signal input port 21, so that the first detection circuit 22 detects the status parameter information of the battery pack.

As shown in FIG. 5, the first detection circuit 22 includes a first voltage detection circuit 221. The first voltage detection circuit 221 is connected to the signal input port 21, and is configured to detect voltage information of the battery pack.

In this embodiment, the first voltage detection circuit 221 may be an AD circuit. The peripheral differential detection circuit 23 detects voltage information of the battery pack, and sends the voltage information to the first voltage detection circuit 221 of the high-voltage management chip 20 through the signal input port 21. The first voltage detection circuit 221 obtains and converts the voltage information.

As shown in FIG. 5, the first detection circuit 22 includes a first current detection circuit 222. The first current detection circuit 222 is connected to the signal input port 21, and is configured to detect current information of the battery pack.

Specifically, the first current detection circuit 222 may be an AD circuit. The peripheral differential detection circuit 23 detects a current signal of the battery pack, and sends the current information to the first current detection circuit 222 of the high-voltage management chip 20 through the signal input port 21. The first current detection circuit 222 obtains the current information, and converts the current information.

In this embodiment, the processor chip 40 managing the battery management system according to the status parameter information of the battery cell and/or the status parameter information of the battery pack includes: the processor chip 40 estimates a state-of-charge value and/or a state-of-health value of the battery pack according to the voltage information and the current information of the battery pack.

Specifically, the first voltage detection circuit 221 and the first current detection circuit 222 of the high-voltage management chip 20 separately obtain voltage information and current information of the battery pack, and send the voltage information and the current information to the processor chip 40 through the dedicated integrated chip 30. The processor chip 40 estimates a state-of-charge value and/or a state-of-health value based on an SOC algorithm according to the voltage information and the current information of the battery pack. Further, the processor chip 40 may perform power supply information scheduling, adjustment of an operating status of each electric unit, and the like based on a state of charge of the battery pack.

In this embodiment of this application, the high-voltage management chip 20 may have a data processing capability, for example, may perform corresponding estimation based on the status parameter information of the battery pack and may share a data processing task of the processor chip 40, thereby reducing a data processing workload of the processor chip 40 and improving data processing efficiency of the processor chip 40.

As shown in FIG. 5, the high-voltage management chip 20 includes a data processing circuit 24. The data processing circuit 24 is connected to the first voltage detection circuit 221 and the first current detection circuit 222 separately, and is configured to estimate a state-of-charge value and/or a state-of-health value of the battery pack according to the voltage information and the current information of the battery pack.

In this embodiment, the data processing circuit 24 may be a digital logic circuit, but this digital logic circuit has a data processing capability, namely, a stronger data processing capability compared with a simple digital logic circuit. For example, the data processing circuit 24 may estimate a state of charge and/or a state of health of the battery pack or the like, to share a computing task of the processor chip 40 and improve data processing efficiency, and may further perform corresponding function protection, fault processing, or the like based on a data processing result.

In this embodiment, the processor chip 40 may estimate a state-of-charge value of the battery pack based on the status parameter information of the battery cell and/or the status parameter information of the battery pack. Specifically, based on different state-of-charge value estimation algorithms, for example, a state-of-charge estimation method based on status parameters of the battery cell and a state-of-charge estimation method based on status parameters of the battery pack, the processor chip 40 may estimate a state-of-charge value of the battery pack according to the status parameter information of the battery cell, or the processor chip 40 may estimate a state-of-charge value of the battery pack according to the status parameter information of the battery pack, or the processor chip 40 may estimate a state-of-charge value of the battery pack by combining the status parameter information of the battery cell and the status parameter information of the battery pack.

Further, the processor chip 40 may obtain, through the dedicated integrated chip 30, the state-of-charge value of the battery pack estimated by the high-voltage management chip 20, and verify battery status according to the state-of-charge value of the battery pack estimated by the processor chip 40 and the state-of-charge value of the battery pack estimated by the high-voltage management chip 20. For example, if the two values are consistent, the battery status is normal; or otherwise if there is a difference between the two values and goes beyond a tolerance range, it is considered that the battery pack is abnormal. In this way, mutual verification can be implemented.

In some embodiments, as shown in FIG. 5, the first detection circuit 22 includes an insulation resistance detection circuit 223. The insulation resistance detection circuit 223 is connected to the signal input port 21, and the insulation resistance detection circuit 223 is configured to detect resistance between the power cord of the battery pack and an insulation ground of a vehicle body. The data processing circuit 24 is further configured to determine a status of current leakage of the battery pack according to the resistance, give an alarm when there is current leakage, and perform processing in a timely manner.

Specifically, the insulation resistance detection circuit 223 may be an AD circuit, and may detect the insulation resistance through a peripheral insulation resistance detection bridge. The insulation resistance detection circuit 223 obtains the resistance through the signal input port 21, and sends the resistance to the data processing circuit 24. The data processing circuit 24 may compute and store current insulation resistance of the battery pack, thereby improving safety.

In this embodiment, the high-voltage management chip 20 further includes a first safety diagnosis circuit 25. The first safety diagnosis circuit 25 is connected to the first detection circuit 22, and is configured to identify whether the status parameter information of the battery pack is abnormal, and perform safety protection when the status parameter information of the battery pack is abnormal, for example, disconnect the power supply circuit of the battery pack.

Specifically, the first safety diagnosis circuit 25 includes a first current diagnosis circuit 251. The first current diagnosis circuit 251 is connected to the first current detection circuit 222, and is configured to identify whether there is overcurrent in the battery pack according to the current information of the battery pack, and perform overcurrent protection when there is overcurrent in the battery pack.

Specifically, the first current detection circuit 222 receives the current information of the battery pack through the signal input port 21, and sends the current information to the first current diagnosis circuit 251. The first current diagnosis circuit 251 identifies whether a current value in the current information exceeds an overcurrent threshold, and if yes, determines that there is overcurrent in the battery pack. In this case, disconnection protection, or the like may be performed through a monitoring loop, and an overcurrent protection trigger signal may be fed back to the processor chip 40, to further perform overcurrent protection processing.

To be specific, the signal input port 21, the first current detection circuit 222, the first current diagnosis circuit 251, and the processor chip 40 form a current detection and protection loop. The loop detects a differential current between two ends of the battery group, converts a differential current value into a numerical value, stores the numerical value, and performs related computing. During the detection, overcurrent protection is continuously performed for input current signals, and related protection measures such as open-circuit protection and short-circuit protection are implemented for the current monitoring loop.

The first safety diagnosis circuit 25 includes a first voltage diagnosis circuit 252. The first voltage diagnosis circuit 252 is connected to the first voltage detection circuit 221, and is configured to identify whether there is overvoltage or undervoltage in the battery pack according to the voltage information of the battery pack, and perform overvoltage or undervoltage protection when there is overvoltage or undervoltage in the battery pack.

Specifically, the first voltage detection circuit 221 receives the voltage information of the battery pack through the signal input port 21, and sends the voltage information to the first voltage diagnosis circuit 252. The first voltage diagnosis circuit 252 identifies whether a voltage value in the voltage information exceeds an overvoltage threshold or is lower than an undervoltage threshold. If the overvoltage threshold is exceeded, it is determined that there is overvoltage in the battery pack; or if the voltage value is lower than the undervoltage threshold, it is determined that there is undervoltage in the battery pack. In this case, disconnection protection or the like may be performed on the monitoring loop, and an overvoltage or undervoltage protection trigger signal may be fed back to the processor chip 40, to further perform overvoltage or undervoltage protection processing.

To be specific, the signal input port 21, the first voltage detection circuit 221, the first voltage diagnosis circuit 252, and the processor chip 40 form a high-voltage detection and protection loop. The loop detects a differential voltage between two ends of the battery group, converts a differential voltage value into a numerical value, and stores the numerical value. During the detection, overvoltage/undervoltage protection is continuously performed for input signals, and related protection measures such as open-circuit protection and short-circuit protection may be implemented for the monitoring loop.

As shown in FIG. 5, the high-voltage management chip 20 includes a second general-purpose input/output interface circuit 26. The second general-purpose input/output interface circuit 26 is connected to an external sensor or an external load, and is configured to collect information of the external sensor or output a control signal to the external load. For example, the external sensor may include a temperature sensor, configured to detect temperature information of the high-voltage management chip 20. In addition, the high-voltage management chip 20 may be connected to an external load through the second general-purpose input/output interface circuit 26, to implement control and the like over the external load.

In this embodiment, the high-voltage management chip 20 further includes a first temperature detection circuit 27 and a first temperature diagnosis circuit 28.

The first temperature detection circuit 27 is connected to an external temperature sensor through the second general-purpose input/output interface circuit 26, to detect temperature information of the high-voltage management chip 20. The first temperature diagnosis circuit 28 is connected to the first temperature detection circuit 27, and is configured to identify whether there is overtemperature in the high-voltage management chip 20 according to the temperature information of the high-voltage management chip 20, and perform overtemperature protection when there is overtemperature in the high-voltage management chip 20.

Specifically, the first temperature detection circuit 27 may receive a temperature detection signal through the second general-purpose input/output interface 26. In other words, the second general-purpose input/output interface 26, the first temperature detection circuit 27, the first temperature diagnosis circuit 28, and the processor chip 40 form a temperature detection and protection loop. The loop performs temperature detection on the current detection loop of the high-voltage management chip 20, converts a temperature-sensitive voltage value into a numerical value, stores the numerical value, performs specific compensation and protection measures for the current collection loop through a temperature-sensitive parameter, such as continuous thermal switch protection, and performs related protective measures such as open-circuit protection and short-circuit protection for the temperature-sensitive monitoring loop.

In this embodiment, the processor chip 40 is further configured to obtain at least one of detection information, computing result information, safety diagnosis information, and safety alarm information of the high-voltage management chip 20 through the dedicated integrated chip 30. For example, the processor chip 40 may obtain the voltage information, the current information, and the like of the battery pack that are detected by the high-voltage management chip 20, and may obtain an SOC value of the battery pack that is estimated by the high-voltage management chip 20 to perform mutual verification; may also obtain safety diagnosis information of the high-voltage management chip 20 such as overvoltage, overcurrent, undervoltage, and overtemperature; and may feed back safety alarm information to the processor chip 40 when the high-voltage management chip 20 determines through diagnosis that a safety exception occurs in the battery pack. The processor chip 40 may determine a protection measure based on a diagnosis result. For example, the protection measure may include: stopping a related detection step, stopping a related computing step to further perform detection and diagnosis such as open-circuit detection or short-circuit detection, and giving an alarm to an upper-level control system.

In short, the high-voltage management chip 20 in this embodiment of this application may detect the differential voltage and the differential current between two ends of the battery group, detect the isolation resistance of the battery group and an ambient temperature-sensitive numerical value, and provide computing, functional safety protection, safety measures, and the like.

As shown in FIG. 5, the high-voltage management chip 20 further includes a third daisy-chain serial peripheral interface circuit 201. As shown in FIG. 1 and FIG. 2, the high-voltage management chip 20 is connected to the second daisy-chain serial peripheral interface circuit 303 of the dedicated integrated chip 30 through the third daisy-chain serial peripheral interface circuit 201, so that communication between the dedicated integrated chip 30 and the high-voltage management chip 20 is implemented through the third daisy-chain serial peripheral interface circuit 201 and the second daisy-chain serial peripheral interface circuit 303. The daisy-chain serial peripheral interface circuits may play a function of communication isolation, reduce signal crosstalk, and improve communication stability.

The high-voltage management chip 20 includes at least one of the second standard serial peripheral interface circuit and a second I2C bus interface circuit, and the at least one of the second standard serial peripheral interface circuit and the second I2C bus interface circuit may be configured for connection between the high-voltage management chip 20 and the processor chip 40. In this application, the high-voltage management chip 20 is connected to the processor chip 40 through the dedicated integrated chip 30. Therefore, the second standard serial peripheral interface circuit and the second I2C bus interface circuit may still be retained as standby interface circuits.

The high-voltage management chip 20 includes a second controller area network bus interface circuit 202. The second controller area network bus interface circuit 202 is configured to connect to an external communication bus to obtain external bus information, to implement data exchange between the high-voltage management chip 20 and the external communication bus.

Specifically, the processor chip 40 is in bridge connection with the dedicated integrated chip 30, and is connected to the high-voltage management chip 20 through the daisy-chain serial peripheral interface circuits. The processor chip 40 participates in the management work of the high-voltage management chip 20 through this connection. The processor chip 40 may configure related parameters (operation behavior, operating mode, interface parameters, and time parameters), analyze a status of a high-voltage signal by reading differential data collected by the high-voltage management chip 20 and computing data, and may also analyze an operating status of the high-voltage management chip 20 by reading related registered data and functional safety detection data. In addition, the processor chip 40 may further configure related parameters through an analysis interface, to more intelligently manage a supervised chip system.

An internal structure of the analog front-end chip 10 in this embodiment of this application is described below.

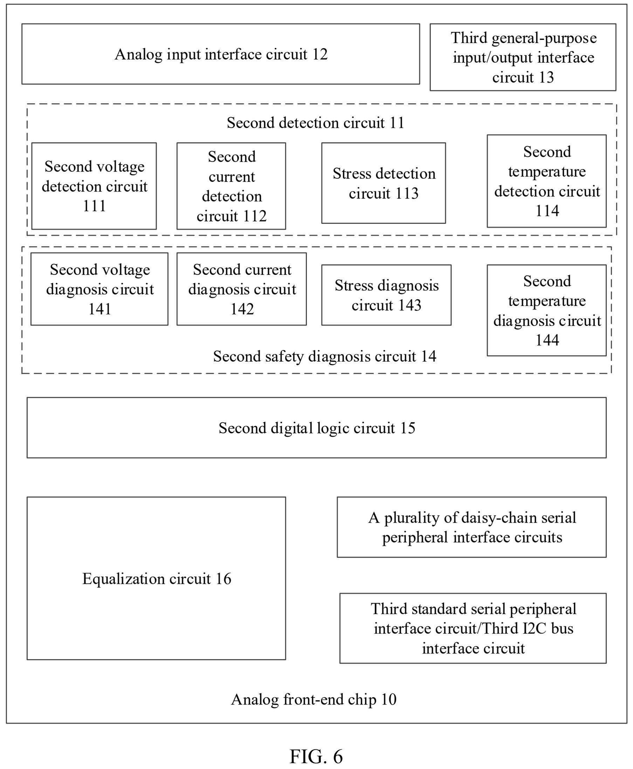

FIG. 6 is a diagram of an internal structure of an analog front-end chip 10 according to an embodiment of this application. As shown in FIG. 6, the analog front-end chip 10 includes a second detection circuit 11. The second detection circuit 11 is connected to the battery group, and is configured to detect the status parameter information of the battery cell in the battery group, such as a current value, a voltage value, a stress, and a temperature, for use in safety diagnosis and monitoring of the analog front-end chip 10. The status parameter information may also be sent to the processor chip 40 through the dedicated integrated chip 30 for the processor chip 40 to properly manage the battery management system 100.

As shown in FIG. 6, the analog front-end chip 10 further includes an analog input interface circuit 12. The second detection circuit 11 is connected to an external detection circuit through the analog input interface circuit 12, to detect the status parameter information of the battery cell in the battery group.

Specifically, the second detection circuit 11 may be an AD circuit, which detects the status parameter information of the battery cell in the battery group, such as a voltage, a current, and a stress, through the external detection circuit, and sends analog values of the detected status parameter information to the second detection circuit 11 through the analog input interface circuit 12. The second detection circuit 11 converts and stores the analog values of the status parameter information of the battery cell.

The analog front-end chip 10 further includes a third general-purpose input/output interface circuit 13. The third general-purpose input/output interface circuit 13 is connected to an external sensor, and the second detection circuit 11 is connected to the external sensor through the third general-purpose input/output interface circuit 13, to detect the status parameter information of the battery cell in the battery group, such as temperature information.

As shown in FIG. 6, the second detection circuit 11 includes a second voltage detection circuit 111, and the second voltage detection circuit 111 is configured to collect voltage information of the battery cell in the battery group. For example, the second voltage detection circuit 111 may be an AD circuit. An external voltage detection circuit detects a voltage value of the battery cell, and transmits the voltage value to the second voltage detection circuit 111 through the analog input interface circuit 12. The second voltage detection circuit 111 converts the analog voltage value, to implement voltage detection.

The second detection circuit 11 further includes a second current detection circuit 112, and the second current detection circuit 112 is configured to collect current information of the battery cell in the battery group. For example, the second current detection circuit 112 may be an AD circuit. An external current detection circuit detects a current value of the battery cell, and transmits the current value to the second current detection circuit 112 through the analog input interface circuit 12. The second current detection circuit 112 converts the analog current value, to implement current detection.

The second detection circuit 11 further includes a stress detection circuit 113. The stress detection circuit 113 is configured to detect stress information of the battery cell in the battery group. For example, the stress detection circuit 113 may be an AD circuit. An external stress detection circuit detects a stress value of the battery cell, and transmits the stress value to the stress detection circuit 113 through the analog input interface circuit 12. The stress detection circuit 113 converts the analog stress value, to implement stress detection.

The second detection circuit 11 may further include a second temperature detection circuit 114. The second temperature detection circuit 114 is configured to detect temperature information of the battery cell in the battery group. For example, the second temperature detection circuit 114 may be an AD circuit. An external sensor detects temperature information, and transmits the temperature information to the second temperature detection circuit 114 through the third general-purpose input/output interface circuit 13.

As shown in FIG. 6, the analog front-end chip 10 further includes a second safety diagnosis circuit 14. The second safety diagnosis circuit 14 is connected to the second detection circuit 11, and is configured to identify whether the status parameter information of the battery cell in the battery group is abnormal, and perform safety protection when the status parameter information of the battery cell is abnormal.

The analog front-end chip 10 further includes a second digital logic circuit 15. The second digital logic circuit 15 is connected to the second safety diagnosis circuit 14, and is configured to generate exception information when the status parameter information of the battery cell in the battery group is abnormal, to give an alarm prompt.

The second safety diagnosis circuit 14 includes a second voltage diagnosis circuit 141. The second voltage diagnosis circuit 141 is connected to the second voltage detection circuit 111, and is configured to identify whether there is overvoltage or undervoltage for a voltage of the battery cell in the battery group, and perform overvoltage or undervoltage protection when there is overvoltage or undervoltage for the voltage of the battery cell.

In some embodiments, the second voltage diagnosis circuit 141 is further configured to identify whether a voltage of the battery group is abnormal and identify whether voltages of the internal components of the analog front-end chip 10 are abnormal, and perform voltage safety protection when an exception occurs.

Specifically, the analog input interface circuit 12, the second voltage detection circuit 111, the second voltage diagnosis circuit 141, and the second digital logic circuit 15 form a voltage detection and protection loop. The loop detects an operating voltage between two ends of the connected battery group or battery cell, converts a value of the voltage between the two ends of the battery cell, namely, a positive electrode and a negative electrode of the battery cell, into a numerical value, and stores the numerical value. During the detection, overvoltage/undervoltage protection is continuously performed for input signals, open-circuit protection and short-circuit protection may be implemented for the monitoring loop, and related monitoring and protection measures may be implemented for components of the loop and parameters of the components.

The second safety diagnosis circuit 14 further includes a second current diagnosis circuit 142. The second current diagnosis circuit 142 is connected to the second current detection circuit 112, and is configured to identify whether there is overcurrent for a current of the battery cell in the battery group, and perform overcurrent protection when there is overcurrent for the current of the battery cell.

In this embodiment, the second current detection circuit 112 is further configured to detect a current of the battery group and currents of the internal components of the analog front-end chip 10; and the second current diagnosis circuit 142 is further configured to diagnose whether the current of the battery group is abnormal and identify whether the currents of the internal components of the analog front-end chip 10 are abnormal, and perform current abnormality safety protection when there is an abnormal current.

Specifically, the analog input interface circuit 12, the second current detection circuit 112, the second current diagnosis circuit 142, and the second digital logic circuit 15 form a current detection and protection loop. The loop detects a current between two ends of the battery group, converts a value of the current into a numerical value, and stores the numerical value. During the detection, overcurrent protection is continuously performed for input current signals, protection measures such as open-circuit protection, short-circuit protection, and overtemperature protection are implemented for the current monitoring loop, and related monitoring and protection measures are implemented for components of the loop and parameters of the components.

The second safety diagnosis circuit 14 further includes a stress diagnosis circuit 143. The stress diagnosis circuit 143 is configured to identify whether a stress of the battery cell in the battery group is abnormal, and perform stress abnormality safety protection when the stress is abnormal.

Specifically, the analog input interface circuit 12, the stress detection circuit 113, the stress diagnosis circuit 143, and the second digital logic circuit 15 form a current detection and protection loop. The loop detects stresses inside and outside the battery cell, converts stress values into numerical values, and stores the numerical values. During the detection, input stress signals are continuously subject to threshold restriction, protection measures such as open-circuit protection, short-circuit protection, and overtemperature protection are implemented for the stress monitoring loop, and related monitoring and protection measures are implemented for components of the loop and parameters of the components.

The second safety diagnosis circuit 14 further includes a second temperature diagnosis circuit 144. The second temperature diagnosis circuit 144 is connected to the second temperature detection circuit 114, and is configured to identify whether there is overtemperature for a temperature of the battery cell in the battery group, and perform overtemperature safety protection when there is overtemperature for the temperature of the battery cell.

Specifically, the third general-purpose input/output interface circuit 13, the second temperature detection circuit 114, the second temperature diagnosis circuit 144, and the second digital logic circuit 15 form a temperature detection and protection loop. The loop detects a temperature change outside the battery that is connected to the current analog front-end chip, converts the foregoing temperature-sensitive voltage value into a numerical value, and stores the numerical value. During the detection, protection such as over-temperature, low-temperature, and thermal switch protection is continuously performed for detected temperature-sensitive signals, open-circuit protection and short-circuit protection are implemented for the temperature-sensitive monitoring loop, and related monitoring and protection measures are implemented for components of the loop and parameters of the components.

In short, the analog front-end chip 10 in this embodiment of this application is provided with a plurality of safety protection functions, for example, including but not limited to overvoltage/undervoltage protection, overtemperature protection, low-temperature protection, stress protection, and open-circuit/short-circuit protection.

In this embodiment, the processor chip 40 may further obtain at least one of detection information, safety diagnosis information, safety alarm information, and computing result information of the analog front-end chip 10 through the dedicated integrated chip 30, to perform task scheduling and management based on the obtained information of the analog front-end chip 10. The processor chip 40 may further control status transition of the analog front-end chip 10, and determine a manner of obtaining the information, a communication mode, and the like.

In this embodiment, when managing the battery management system 100, the processor chip 40 may be specifically configured to: determine battery state according to the status parameter information of the battery cell and the status parameter information of the battery pack, and determine, according to the battery state, whether to continue to charge or discharge the battery pack and whether to stop charging or discharging the battery pack, for example, determine whether to perform charging or discharging or whether to stop charging according to a state-of-charge value of the battery pack.

In some embodiments, as shown in FIG. 6, the high-voltage management chip 20 further includes an equalization circuit 16.

The processor chip 40 being configured to manage the battery management system 100 according to the status parameter information of the battery cell and the status parameter information of the battery pack includes: the processor chip 40 is configured to generate power equalization information when it is determined, according to the status parameter information of the battery cell in the battery group, that the power of the battery cell in the battery group is unbalanced, and forward the power equalization information to the front-end analog chip 10 through the dedicated integrated chip 30. The equalization circuit 16 of the analog front-end chip 10 is configured to perform power equalization processing on the battery cell in the battery group according to the power equalization information, thereby improving power supply equalization of the battery cell, improving the utilization of the battery cell, and prolonging service life of the battery pack.

Specifically, to prevent capacity inconsistency between the battery cells in the battery group connected to the analog front-end chip 10 or capacity inconsistency between a battery cell in the battery group and a battery cell in another battery group, the analog front-end chip 10 may start an equalization function and release an electric quantity of a battery cell whose capacity is slightly higher in the battery group.

Further, in this embodiment, the battery pack may include a plurality of battery groups, and each battery group is correspondingly connected to an analog front-end chip 10. As shown in FIG. 1, there are a plurality of analog front-end chips 10, and the plurality of analog front-end chips 10 are connected in series. Each analog front-end chip 10 is configured to detect status parameter information of a battery cell in the correspondingly connected battery group.

In some embodiments, the plurality of analog front-end chips 10 may be connected in a daisy-chain manner. As shown in FIG. 1, there are two first daisy-chain serial peripheral interface circuits 301 through which the dedicated integrated chip 30 is connected to the analog front-end chip 10.

In addition, each analog front-end chip 10 includes at least two daisy-chain serial peripheral interface circuits. For example, each analog front-end chip 10 includes a fourth daisy-chain serial peripheral interface circuit 101 and a fifth daisy-chain serial peripheral interface circuit 102. In the plurality of analog front-end chips 10 connected in series, a head-end analog front-end chip 10 is connected to one first daisy-chain serial peripheral interface circuit 301 of the dedicated integrated chip 30 through the fourth daisy-chain serial peripheral interface circuit 101, and a tail-end analog front-end chip 10 is connected to the other first daisy-chain serial peripheral interface circuit 301 of the dedicated integrated chip 30 through the fifth daisy-chain serial peripheral interface circuit 102, to implement communication between each analog front-end chip 10 and the dedicated integrated chip 30.

Further, as shown in FIG. 1, in the plurality of analog front-end chips 10 connected in series, an n^{th} analog front-end chip 10 is connected to the fourth daisy-chain serial peripheral interface circuit 101 of an (n+1)^{th} analog front-end chip 10 through the fifth daisy-chain serial peripheral interface circuit 102, wherein 1 ≤ n < n+1 ≤ N, and N is a total quantity of the plurality of analog front-end chips 10 connected in series.

In some embodiments, as shown in FIG. 6, the analog front-end chip 10 includes at least one of a third standard serial peripheral interface circuit and a third I2C bus interface circuit, and the at least one of the third standard serial peripheral interface circuit and the third I2C bus interface circuit is a standby interface circuit. When the analog front-end chip 10 is not connected to the processor chip 40 through the dedicated integrated chip 30, communication connection between the analog front-end chip 10 and the processor chip 40 may be implemented through the standby interface circuit, or the analog front-end chip 10 may be connected to another control system or monitoring system through the standby interface circuit. This is not specifically limited herein.

In short, the analog front-end chip 10 in this embodiment of this application may be connected to a single battery cell, or may be connected to a battery group in which a plurality of battery cells are cascaded. The analog front-end chip 10 may collect battery parameters such as a current, a voltage, a stress, and a temperature, and provides related functional safety protection. In addition, the analog front-end chip 10 may perform computing such as SOC and SOH computing according to these parameters.

Specifically, the processor chip 40 is in bridge connection with the dedicated integrated chip 30, and may be connected to the analog front-end chip 10 through the daisy-chain serial peripheral interface circuits. The processor chip 40 may participate in the management work of the analog front-end chip 10 through this connection. The processor chip 40 may configure related parameters (operation behavior, operating mode, interface parameters, and time parameters), and analyze a collected battery-related operating status by reading data collected by the analog front-end chip 10 and computing data. The processor chip 40 further performs an equalization operation on a related chip and a related battery according to an analysis result, and analyzes an operating status of the analog front-end chip 10 by reading related registered data and functional safety detection data, to help further configure related parameters.

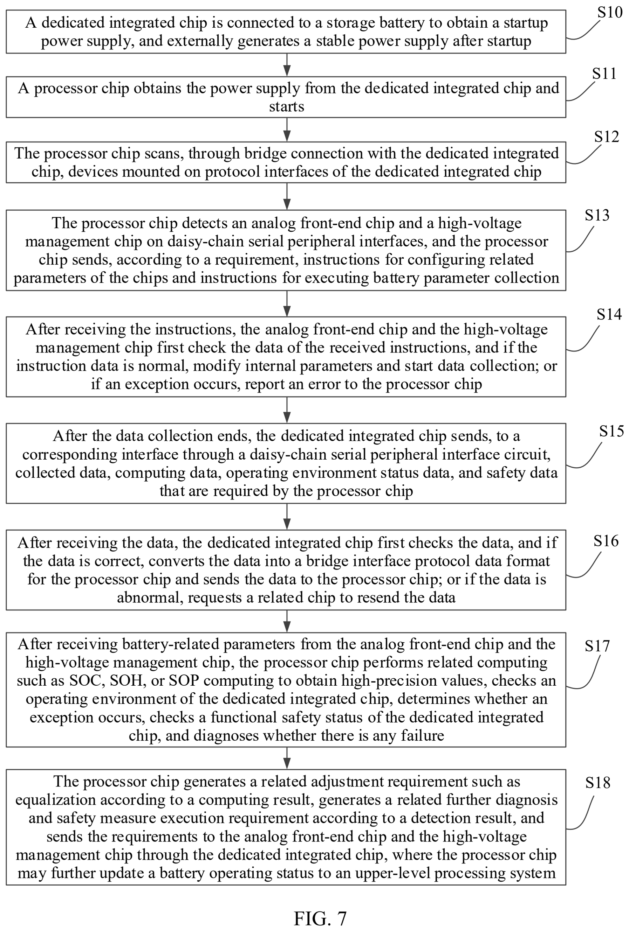

Based on the description of the foregoing embodiments, FIG. 7 is a flowchart of signal exchange between various chips of a battery management system 100 according to an embodiment of this application. As shown in FIG. 7, the flowchart includes the following steps.

S10: a dedicated integrated chip is connected to a storage battery to obtain a startup power supply, and externally generates a stable power supply after startup.

S11: a processor chip obtains the power supply from the dedicated integrated chip and starts.

S12: the processor chip scans, through bridge connection with the dedicated integrated chip, devices mounted on protocol interfaces of the dedicated integrated chip.

S13: the processor chip detects an analog front-end chip and a high-voltage management chip on daisy-chain serial peripheral interfaces, and the processor chip sends, according to a requirement, instructions for configuring related parameters of the chips and instructions for executing battery parameter collection.

S14: after receiving the instructions, the analog front-end chip and the high-voltage management chip first check the data of the received instructions, and if the instruction data is normal, modify internal parameters and start data collection; or if an exception occurs, report an error to the processor chip.

S15: after the data collection ends, the dedicated integrated chip sends, to a corresponding interface through a daisy-chain serial peripheral interface circuit, collected data, computing data, operating environment status data, and safety data that are required by the processor chip.

S16: after receiving the data, the dedicated integrated chip first checks the data, and if the data is correct, converts the data into a bridge interface protocol data format for the processor chip and sends the data to the processor chip; or if the data is abnormal, requests a related chip to resend the data.

S17: after receiving battery-related parameters from the analog front-end chip and the high-voltage management chip, the processor chip performs related computing such as SOC, SOH, or SOP computing to obtain high-precision values, checks an operating environment of the dedicated integrated chip, determines whether an exception occurs, checks a functional safety status of the dedicated integrated chip, and diagnoses whether there is any failure.

S18: the processor chip generates a related adjustment requirement such as equalization according to a computing result, generates a related further diagnosis and safety measure execution requirement according to a detection result, and sends the requirements to the analog front-end chip and the high-voltage management chip through the dedicated integrated chip, wherein the processor chip may further update a battery operating status to an upper-level processing system.

On the whole, the battery management system 100 in this embodiment of this application is based on the architecture of the analog front-end chip 10, the high-voltage management chip 20, the dedicated integrated chip 30, and the processor chip 40, thereby reducing a quantity of independent components, costs, wiring, and system design complexity. In addition, the high-voltage management chip 20 may perform related computing on signals collected by the high-voltage management chip 20, and the processor chip 40 needs only to schedule a result of the computing performed by the high-voltage management chip 20, and then further performs improvement according to system data. Therefore, the processor chip 40 has higher data obtaining efficiency and data processing efficiency, so that the battery management system 100 is more stable and reliable. In addition, the dedicated integrated chip 30 provides power supplies that satisfy different requirements for the processor chip 40, the high-voltage management chip 20, and extended devices, thereby improving power control of the system over the extended devices, reducing complexity of circuits of the system which is different from a conventional system in which a power supply is separately supplied by a discrete device, and improving consistency of drive power supplies. In addition, in this embodiment of this application, each chip has complete functional safety measures. Each chip can detect and diagnose a fault around the chip, and is subject to systematic safety monitoring performed by the processor chip 40, thereby ensuring integrity of high-level vehicle safety of the system in this application and reducing a fault rate of the system.

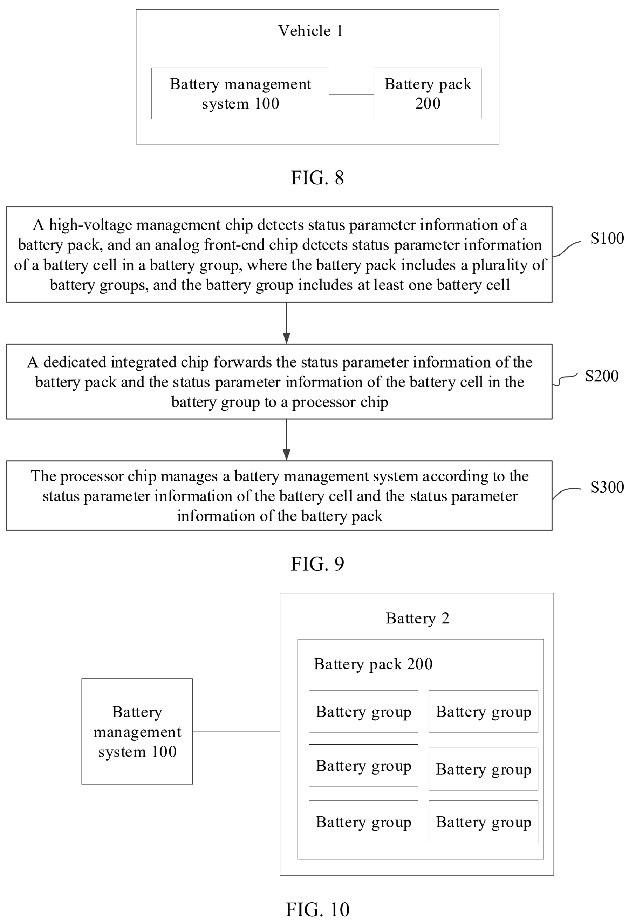

Based on the battery management system 100 in the foregoing embodiments, an embodiment of this application according to a second aspect provides a battery 2, as shown in FIG. 10.

The battery 2 includes a battery pack 200. The battery pack 200 includes a plurality of battery groups, and each battery group includes at least one battery cell. The battery pack 200 is connected to the battery management system 100 in the foregoing embodiments, and each battery group is also connected to the battery management system 100.

Therefore, the battery 2 in this embodiment of this application is connected to the battery management system 100 in the foregoing embodiments. The battery management system 100 has a compact structure, a simple design, and high system safety and reliability, thereby improving safety of use of the battery.

Based on the battery management system 100 in the foregoing embodiments, an embodiment of this application according to a third aspect further provides a vehicle 1.

FIG. 8 is a block diagram of a vehicle 1 according to an embodiment of this application. As shown in FIG. 8, the vehicle 1 according to this embodiment of this application includes a battery pack 200 and the battery management system 100 in the foregoing embodiments, and the battery management system 100 is connected to the battery pack 200.

In some embodiments, the battery pack 200 may include a plurality of battery groups, and each battery group includes at least one battery cell.

Therefore, the vehicle 1 in this embodiment of this application employs the battery management system 100 in the foregoing embodiments, with high operating efficiency, safety, and reliability, and numerous application scenarios, thereby improving efficiency and safety of vehicle battery management.

Based on the battery management system 100 in the foregoing embodiments, an embodiment of this application according to a fourth aspect further provides a battery management method.

FIG. 9 is a flowchart of a battery management method according to an embodiment of this application. As shown in FIG. 9, the method includes the following steps.

S100: a high-voltage management chip detects status parameter information of a battery pack, and an analog front-end chip detects status parameter information of a battery cell in a battery group, wherein the battery pack includes a plurality of battery groups, and the battery group includes at least one battery cell.

S200: a dedicated integrated chip forwards the status parameter information of the battery pack and the status parameter information of the battery cell in the battery group to a processor chip.

S300: the processor chip manages a battery management system according to the status parameter information of the battery cell and the status parameter information of the battery pack.

According to the battery management method in this embodiment of this application, data exchange between the analog front-end chip and the processor chip and data exchange between the high-voltage management chip and the processor chip are implemented through the dedicated integrated chip, to save interface resources of the processor chip, reduce an interface load of the processor chip, and improve data processing efficiency of the processor chip, thereby improving system safety and reliability.

In this embodiment, managing, by the processor chip, the battery management system may include, but is not limited to, obtaining battery state through monitoring data, and determining whether to perform charging or discharging and when to stop charging or discharging. The processor chip may estimate a state-of-charge value of the battery pack according to the status parameter information of the battery pack and/or the status parameter information of the battery cell, and may further perform mutual verification with another estimation module. Furthermore, the processor chip may further perform monitoring, management and control, and the like that are related to functional safety. In addition, the processor chip may further perform parameter configuration on each chip, and perform task scheduling, adjustment of an operating status of each chip, and the like based on the monitoring data.

In some embodiments, managing, by the processor chip, the battery management system according to the status parameter information of the battery cell and the status parameter information of the battery pack includes: estimating, by the processor chip, a state-of-charge value and/or a state-of-health value of the battery pack according to voltage information and current information of the battery pack, to monitor and manage a status of the battery pack. For information about an estimation algorithm, refer to related technical description.

Further, the processor chip may determine, according to a state of charge of the battery pack, whether to charge or discharge the battery pack and whether to stop charging or discharging the battery pack.

In some embodiments, managing, by the processor chip, the battery management system according to the status parameter information of the battery cell and the status parameter information of the battery pack includes: determining, by the processor chip according to the status parameter information of the battery cell in the battery group, that the power of the battery cell in the battery group is unbalanced, generating power equalization information, and forwarding the power equalization information to the front-end analog chip through the dedicated integrated chip, so that an equalization circuit of the analog front-end chip may perform power equalization processing on the battery cell in the battery group.

In some embodiments, the processor chip may further manage and control, based on the monitoring data, power supply for an internal electric chip of the battery management system and connection/disconnection of an external electric unit.

For example, the processor chip generates power supply configuration information according to a power supply requirement of an internal electric chip of the battery management system, and sends the power supply configuration information to the dedicated integrated chip, to manage the battery management system in providing an operating power supply for the internal electric chip.

The dedicated integrated chip may control, according to the power supply configuration information, a power supply circuit of the dedicated integrated chip to provide an operating power supply for at least one of internal electric chips of the battery management system, to manage and control internal power supply.

For another example, the processor chip generates a power switch channel selection control signal according to an electric power demand of an external electric unit, and sends the power switch channel selection control signal to the dedicated integrated chip, to manage the battery management system in connecting or disconnecting power supply for the external electric unit.

The dedicated integrated chip controls, according to the power switch channel selection control signal, connection/disconnection between the external electric unit connected to the power supply circuit and a power supply side, or controls connection/disconnection between the external electric unit and a power supply ground side, to manage the power supply for the external electric unit.

In some embodiments of this application, the processor chip sends configuration information of the dedicated integrated chip to the dedicated integrated chip, obtains interface circuit transfer information of the dedicated integrated chip, and obtains at least one of safety monitoring information, safety alarm information, and operating status information of the dedicated integrated chip.

In this way, the processor chip may participate in the management work of the dedicated integrated chip. The processor chip may configure related parameters (operation behavior, operating mode, interface parameters, and time parameters), and implement data exchange with another chip through the dedicated integrated chip, thereby saving interface resources of the processor chip and improving data processing efficiency of the processor chip.

In some embodiments, the processor chip sends configuration information of the high-voltage management chip to the high-voltage management chip through the dedicated integrated chip, and obtains detection information of the high-voltage management chip through the dedicated integrated chip. In addition, the processor chip obtains at least one of computing result information, safety diagnosis information, and safety alarm information of the high-voltage management chip through the dedicated integrated chip.

For example, the processor chip may obtain the voltage information, the current information, and the like of the battery pack that are detected by the high-voltage management chip, and may obtain an SOC value of the battery pack that is estimated by the high-voltage management chip to perform mutual verification; may also obtain safety diagnosis information of the high-voltage management chip such as overvoltage, overcurrent, undervoltage, and overtemperature; and may feed back safety alarm information to the processor chip when the high-voltage management chip determines through diagnosis that a safety exception occurs in the battery pack. The processor chip may determine a protection measure based on a diagnosis result. For example, the protection measure may include: stopping a related detection step, stopping a related computing step, further performing detection and diagnosis such as open-circuit detection or short-circuit detection, and giving an alarm to an upper-level control system.

In this way, the processor chip may participate in the management work of the high-voltage management chip through the dedicated integrated chip. The processor chip may configure related parameters (operation behavior, operating mode, interface parameters, and time parameters), analyze a status of a high-voltage signal by reading differential data collected by the high-voltage management chip and computing data, and also analyze an operating status of the high-voltage management chip by reading related registered data and functional safety detection data. In addition, the processor chip may further configure related parameters through an analysis interface, to more intelligently manage a supervised chip system.

In some embodiments, the processor chip sends configuration information of the analog front-end chip to the analog front-end chip through the dedicated integrated chip, and obtains detection information of the analog front-end chip through the dedicated integrated chip. In addition, the processor chip obtains at least one of safety diagnosis information, safety alarm information, and computing result information of the analog front-end chip through the dedicated integrated chip.

In this way, the processor chip may participate in the management work of the analog front-end chip through the dedicated integrated chip. The processor chip may configure related parameters (operation behavior, operating mode, interface parameters, and time parameters), and analyze a collected battery-related operating status by reading data collected by the analog front-end chip and computing data. The processor chip further performs an equalization operation on a related chip and a related battery according to an analysis result, and analyzes an operating status of the analog front-end chip by reading related registered data and functional safety detection data, to help further configure related parameters.

In some embodiments of this application, the high-voltage management chip may have a data processing capability. For example, the high-voltage management chip estimates a state-of-charge value and/or a state-of-health value of the battery pack according to the voltage information and the current information of the battery pack, to share a data processing task of the processor chip, thereby improving data processing efficiency of the processor chip.

Further, the processor chip may obtain, through the dedicated integrated chip, the state-of-charge value of the battery pack estimated by the high-voltage management chip, and verify a status of the battery pack according to the state-of-charge value of the battery pack estimated by the processor chip and the state-of-charge value of the battery pack estimated by the high-voltage management chip, thereby implementing mutual verification and improving accuracy of estimation.

In some embodiments, the status parameter information of the battery pack includes resistance between a power cord of the battery pack and an insulation ground of a vehicle body, and the battery management method further includes: determining, by the high-voltage management chip, a status of current leakage of the battery pack according to the resistance; and when there is current leakage, generating current leakage alarm information, and forwarding the information to the processor chip through the dedicated integrated chip, so that a current leakage alarm can be given and a related protection measure can be performed.

In some embodiments, the high-voltage management chip identifies whether the status parameter information of the battery pack is abnormal, and performs safety protection when the status parameter information of the battery pack is abnormal. For example, this may include at least one of the following:
identifying, by the high-voltage management chip according to the current information of the battery pack, whether there is overcurrent in the battery pack, and performing overcurrent protection when there is overcurrent in the battery pack; and
identifying, by the high-voltage management chip according to the voltage information of the battery pack, whether there is overvoltage or undervoltage in the battery pack, and performing overvoltage or undervoltage protection when there is overvoltage or undervoltage in the battery pack.

In some embodiments, the high-voltage management chip obtains temperature information of the high-voltage management chip, and the high-voltage management chip identifies, according to the temperature information of the high-voltage management chip, whether there is overtemperature in the high-voltage management chip, and performs overtemperature protection when there is overtemperature in the high-voltage management chip.

Similarly, in some embodiments, the analog front-end chip identifies whether the status parameter information of the battery cell is abnormal, and performs safety protection when the status parameter information of the battery cell is abnormal. For example, this includes at least one of the following: identifying, by the analog front-end chip, whether there is overvoltage or undervoltage for a voltage of the battery cell in the battery group, and performing overvoltage or undervoltage protection when there is overvoltage or undervoltage for the voltage of the battery cell; identifying, by the analog front-end chip, whether there is overcurrent for a current of the battery cell, and performing overcurrent protection when there is overcurrent for the current of the battery cell; identifying, by the analog front-end chip, whether a stress of the battery cell in the battery group is abnormal, and perform safety protection when the stress is abnormal; and identifying, by the analog front-end chip, whether there is overtemperature for a temperature of the battery cell in the battery group, and performing overtemperature safety protection when there is overtemperature for the temperature of the battery cell.

In some other embodiments, the battery management method further includes at least one of the following: identifying, by the analog front-end chip, whether a voltage of the battery group is abnormal and identifying whether voltages of internal components of the analog front-end chip are abnormal, and performing voltage safety protection when an exception occurs; and diagnosing, by the analog front-end chip, whether a current of the battery group is abnormal and identifying whether currents of the internal components of the analog front-end chip are abnormal, and performing current protection when there is an abnormal current.

In conclusion, the battery management method in this embodiment of this application is based on an architecture of the analog front-end chip, the high-voltage management chip, the dedicated integrated chip, and the processor chip, to reduce system design complexity, improve data transmission efficiency, and enhance consistency of data transmission paths, thereby improving system stability and reliability. In addition, the high-voltage management chip may perform related computing on signals collected by the high-voltage management chip, and the processor chip needs only to schedule a result of the computing performed by the high-voltage management chip, and then further performs improvement according to system data, thereby improving data processing efficiency. In addition, each chip has complete functional safety measures. Each chip can detect and diagnose a fault around the chip, and is subject to systematic safety monitoring performed by the processor chip, thereby improving battery management and achieving more comprehensive safety protection. Therefore, the battery management system is applicable to a wider range of application scenarios. In particular, the battery management system in embodiments of this application is also applicable to a scenario requiring high efficiency, stability, and safety.

In the description of this specification, reference terms such as "an embodiment", "some embodiments", "exemplary embodiment", "example", "specific example", and "some examples" are intended to indicate that specific features, structures, materials, or characteristics related to the embodiment or example are included in at least one embodiment or example of this application. In this specification, illustrative expressions of the foregoing terms do not necessarily mean a same embodiment or example.

Although embodiments of this application have been shown and described, persons of ordinary skill in the art may understand that various changes, modifications, substitutions, and variations may be made to these embodiments without departing from the principles and purposes of this application, and the scope of this application shall be subject to the claims of this application and their equivalent technologies.

## Claims

1. A battery management system (100), comprising:
an analog front-end chip (10), the analog front-end chip (10) being connected to a battery group and configured to detect status parameter information of a battery cell in the battery group, and the battery group comprising at least one battery cell;
a high-voltage management chip (20), the high-voltage management chip (20) being connected to a power cord of a battery pack (200) and configured to detect status parameter information of the battery pack (200), and the battery pack (200) comprising a plurality of battery groups;
a dedicated integrated chip (30); and
a processor chip (40), the processor chip (40) being electrically connected to the analog front-end chip (10) through the dedicated integrated chip (30), the high-voltage management chip (20) being electrically connected to the processor chip (40) through the dedicated integrated chip (30), and the processor chip (40) being configured to manage the battery management system (100) according to the status parameter information of the battery cell and the status parameter information of the battery pack (200).

2. The battery management system (100) according to claim 1, wherein the dedicated integrated chip (30) comprises:
a power supply circuit (31), the power supply circuit (31) being configured to connect to an external power supply and provide an operating power supply to at least one chip in the battery management system (100).

3. The battery management system (100) according to claim 2, wherein the dedicated integrated chip (30) further comprises:
a power input port (32) and a power output port (33), the power supply circuit (31) being connected to the external power supply through the power input port (32), and the power supply circuit (31) being connected to the processor chip (40) through the power output port (33), to provide an operating power supply for the processor chip (40).

4. The battery management system (100) according to claim 2 or 3, wherein the power supply circuit (31) is connected to the high-voltage management chip (20) through the power output port (33), to provide an operating power supply for the high-voltage management chip (20).

5. The battery management system (100) according to claim 4, wherein the power supply circuit (31) comprises a voltage conversion subcircuit (311), one end of the voltage conversion subcircuit (311) is connected to the external power supply through the power input port (32), and the other end of the voltage conversion subcircuit (311) is connected to the processor chip (40) and the high-voltage management chip (20) and is configured to provide different operating voltages for the processor chip (40) and the high-voltage management chip (20).

6. The battery management system (100) according to any one of claims 2 to 5, wherein
the processor chip (40) is further configured to generate power supply configuration information according to a power supply requirement of an internal electric chip of the battery management system (100), and send the power supply configuration information to the dedicated integrated chip (30), to manage the battery management system (100) in providing an operating power supply for the internal electric chip; and
the dedicated integrated chip (30) further comprises:
a first digital logic circuit (34), the first digital logic circuit (34) being electrically connected to the processor chip (40) and the power supply circuit (31) separately and configured to control, according to the power supply configuration information, the power supply circuit (31) to provide the operating power supply for the internal electric chip of the battery management system (100).

7. The battery management system (100) according to claim 6, wherein the dedicated integrated chip (30) further comprises:
a power switch circuit (35), a first end of the power switch circuit (35) being connected to the power supply circuit (31), a second end of the power switch circuit (35) being suitable for connecting to an external electric unit, and the power switch circuit (35) being configured to control a power supply status of the external electric unit to be a connected or disconnected state.

8. The battery management system (100) according to claim 7, wherein the power switch circuit (35) comprises:
a high-side drive subcircuit (351), a first end of the high-side drive subcircuit (351) being connected to an output end of the power supply circuit (31), a second end of the high-side drive subcircuit (351) being suitable for connecting to a power supply side of a power supply loop of the external electric unit, a third end of the high-side drive subcircuit (351) being suitable for connecting to a positive terminal of the external electric unit, and the high-side drive subcircuit (351) being configured to control connection/disconnection between the external electric unit and the power supply side.

9. The battery management system (100) according to claim 8, wherein the power switch circuit (35) comprises:
a low-side drive subcircuit (352), a first end of the low-side drive subcircuit (352) being connected to an output end of the power supply circuit (31), a second end of the low-side drive subcircuit (352) being suitable for connecting to a power supply ground side of the power supply loop of the external electric unit, a third end of the low-side drive subcircuit (352) being suitable for connecting to a negative terminal of the external electric unit, and the low-side drive subcircuit (352) being configured to control connection/disconnection between the external electric unit and the power supply ground side.

10. The battery management system (100) according to claim 9, wherein the power switch circuit (35) further comprises:
an enabling switch subcircuit (353), one end of the enabling switch subcircuit (353) being connected to the high-side drive subcircuit (351) and the low-side drive subcircuit (352) separately, and the other end of the enabling switch subcircuit (353) being connected to the power supply circuit (31) and configured to control connection/disconnection of the high-side drive subcircuit (351) and the low-side drive subcircuit (352).

11. The battery management system (100) according to claim 10, wherein
the processor chip (40) is further configured to generate a power switch channel selection control signal for the high-side drive subcircuit (351) and the low-side drive subcircuit (352) according to an electric power demand of the external electric unit, and send the power switch channel selection control signal to the dedicated integrated chip (30), to manage the battery management system (100) in connecting or disconnecting power supply for the external electric unit; and
the first digital logic circuit (34) is electrically connected to the enabling switch subcircuit (353), and is configured to control the enabling switch subcircuit (353) according to the power switch channel selection control signal.

12. The battery management system (100) according to claim 3, wherein the dedicated integrated chip (30) further comprises:
an input source detection subcircuit (36), one end of the input source detection subcircuit (36) being connected to the external power supply through the power input port (32), and the other end of the input source detection subcircuit (36) being connected to the first digital logic circuit (34) and configured to detect the external power supply and transmit power supply detection information of the external power supply to the first digital logic circuit (34).

13. The battery management system (100) according to any one of claims 2 to 12, wherein the dedicated integrated chip (30) comprises:
an input source isolation circuit (37), the input source isolation circuit (37) being connected to the external power supply and the power supply circuit (31), and the power supply circuit (31) being connected to the external power supply through the input source isolation circuit (37).

14. The battery management system (100) according to any one of claims 1 to 13, wherein the dedicated integrated chip (30) comprises:
a first daisy-chain serial peripheral interface circuit (301), the dedicated integrated chip (30) being electrically connected to the analog front-end chip (10) through the first daisy-chain serial peripheral interface circuit (301).

15. The battery management system (100) according to claim 14, wherein the dedicated integrated chip (30) comprises:
a first standard serial peripheral interface circuit (302), one end of the first standard serial peripheral interface circuit (302) being electrically connected to the first daisy-chain serial peripheral interface circuit (301), and the other end of the first standard serial peripheral interface circuit (302) being electrically connected to the processor chip (40).

16. The battery management system (100) according to claim 15, wherein
the first standard serial peripheral interface circuit (302) is configured to send standard serial data to the processor chip (40) or receive data from the processor chip (40), and transmit the data received from the processor chip (40) as standard serial data to the first daisy-chain serial peripheral interface circuit (301), and the first daisy-chain serial peripheral interface circuit (301) is configured to convert the standard serial data into corresponding differential data, and send the corresponding differential data to the analog front-end chip (10); and
the first daisy-chain serial peripheral interface circuit (301) is further configured to receive differential data from the analog front-end chip (10), and send the differential data received from the analog front-end chip (10) to the first standard serial peripheral interface circuit (302), and the first standard serial peripheral interface circuit (302) converts the differential data into corresponding standard serial data, and sends the corresponding standard serial data to the processor chip (40).

17. The battery management system (100) according to any one of claims 1 to 16, wherein the dedicated integrated chip (30) comprises:
a second daisy-chain serial peripheral interface circuit (303), the dedicated integrated chip (30) being connected to the high-voltage management chip (20) through the second daisy-chain serial peripheral interface circuit (303).

18. The battery management system (100) according to claim 17, wherein the dedicated integrated chip (30) comprises:
a second standard serial peripheral interface circuit (304), one end of the second standard serial peripheral interface circuit (304) being electrically connected to the second daisy-chain serial peripheral interface circuit (303), and the other end of the second standard serial peripheral interface circuit (304) being electrically connected to the processor chip (40).

19. The battery management system (100) according to claim 18, wherein
the second standard serial peripheral interface circuit (304) is configured to receive data from the processor chip (40), and transmit the data received from the processor chip (40) as standard serial data to the second daisy-chain serial peripheral interface circuit (303), and the second daisy-chain serial peripheral interface circuit (303) is configured to convert the standard serial data into corresponding differential data, and send the corresponding differential data to the high-voltage management chip (20); and
the second daisy-chain serial peripheral interface circuit (303) is further configured to receive differential data from the high-voltage management chip (20), and send the differential data received from the high-voltage management chip (20) to the second standard serial peripheral interface circuit (304), and the second standard serial peripheral interface circuit (304) converts the differential data into corresponding standard serial data, and sends the corresponding standard serial data to the processor chip (40).

20. The battery management system (100) according to claim 14 or 17, wherein the dedicated integrated chip (30) further comprises at least one of a first I2C bus interface circuit, a first universal asynchronous receiver/transmitter interface circuit, and a first controller area network bus interface circuit; and the at least one interface circuit is configured for electrical connection between the daisy-chain serial peripheral interface circuit of the dedicated integrated chip (30) and the processor chip (40), or the at least one interface circuit is configured for communication between the dedicated integrated chip (30) and an external control system.

21. The battery management system (100) according to any one of claims 6 to 11, wherein the dedicated integrated chip (30) further comprises:
a first analog input interface circuit (305), one end of the first analog input interface circuit (305) being electrically connected to an external sensor, and the other end of the first analog input interface circuit (305) being electrically connected to the first digital logic circuit (34) and configured to collect sensor information of the external sensor.

22. The battery management system (100) according to any one of claims 6 to 11, wherein the dedicated integrated chip (30) further comprises:
a first general-purpose input/output interface circuit (306), one end of the first general-purpose input/output interface circuit (306) being electrically connected to a peripheral circuit, and the other end of the first general-purpose input/output interface circuit (306) being connected to the first digital logic circuit (34) and configured to output control information of the first digital logic circuit (34) for the peripheral circuit or collect status information of the peripheral circuit.

23. The battery management system (100) according to any one of claims 2 to 22, wherein the processor chip (40) is further configured to send configuration information of the dedicated integrated chip (30) to the dedicated integrated chip (30), and obtain at least one of interface circuit transfer information, safety monitoring information, safety alarm information, and operating status information of the dedicated integrated chip (30).

24. The battery management system (100) according to any one of claims 1 to 23, wherein the high-voltage management chip (20) comprises:
a signal input port (21), configured to input the status parameter information of the battery pack (200); and
a first detection circuit (22), the first detection circuit (22) being connected to the power cord of the battery pack (200) through the signal input port (21) and configured to detect the status parameter information of the battery pack (200).

25. The battery management system (100) according to claim 24, wherein the high-voltage management chip (20) further comprises:
a peripheral differential detection circuit (23), one end of the peripheral differential detection circuit (23) being connected to the power cord of the battery pack (200), the other end of the peripheral differential detection circuit (23) being connected to the signal input port (21) of the high-voltage management chip (20), and the first detection circuit (22) detecting the status parameter information of the battery pack (200) through the peripheral differential detection circuit (23).

26. The battery management system (100) according to claim 24 or 25, wherein the first detection circuit (22) comprises:
a first voltage detection circuit (221), the first voltage detection circuit (221) being connected to the signal input port (21) and configured to detect voltage information of the battery pack (200).

27. The battery management system (100) according to claim 26, wherein the first detection circuit (22) comprises:
a first current detection circuit (222), the first current detection circuit (222) being connected to the signal input port (21) and configured to detect current information of the battery pack (200).

28. The battery management system (100) according to claim 27, wherein the processor chip (40) being configured to manage the battery management system (100) according to the status parameter information of the battery cell and/or the status parameter information of the battery pack (200) comprises:
the processor chip (40) is configured to estimate a state-of-charge value and/or a state-of-health value of the battery pack (200) according to the voltage information and the current information of the battery pack (200).

29. The battery management system (100) according to claim 27 or 28, wherein the high-voltage management chip (20) further comprises:
a data processing circuit (24), the data processing circuit (24) being connected to the first voltage detection circuit (221) and the first current detection circuit (222) separately and configured to estimate a state-of-charge value and/or a state-of-health value of the battery pack (200) according to the voltage information and the current information of the battery pack (200).

30. The battery management system (100) according to claim 29, wherein the first detection circuit (22) comprises:
an insulation resistance detection circuit, the insulation resistance detection circuit being connected to the signal input port (21) and configured to detect resistance between the power cord of the battery pack (200) and an insulation ground of a vehicle body; and
the data processing circuit is connected to the insulation resistance detection circuit, and is configured to determine a status of current leakage of the battery pack (200) according to the resistance.

31. The battery management system (100) according to any one of claims 26 to 30, wherein the high-voltage management chip (20) further comprises:
a first safety diagnosis circuit (25), the first safety diagnosis circuit (25) being connected to the first detection circuit (22) and configured to identify whether the status parameter information of the battery pack (200) is abnormal and perform safety protection when the status parameter information of the battery pack (200) is abnormal.

32. The battery management system (100) according to claim 31, wherein the first safety diagnosis circuit (25) comprises:
a first current diagnosis circuit (251), the first current diagnosis circuit (251) being connected to the first current detection circuit (222) and configured to identify whether there is overcurrent in the battery pack (200) according to the current information of the battery pack (200) and perform overcurrent protection when there is overcurrent in the battery pack (200).

33. The battery management system (100) according to any one of claims 26 to 32, wherein the first safety diagnosis circuit (25) comprises:
a first voltage diagnosis circuit (252), the first voltage diagnosis circuit (252) being connected to the first voltage detection circuit (221) and configured to identify whether there is overvoltage or undervoltage in the battery pack (200) according to the voltage information of the battery pack (200) and perform overvoltage or undervoltage protection when there is overvoltage or undervoltage in the battery pack (200).

34. The battery management system (100) according to any one of claims 1 to 33, wherein the high-voltage management chip (20) comprises:
a second general-purpose input/output interface circuit (26), the second general-purpose input/output interface circuit (26) being connected to an external sensor or an external load and configured to collect information of the external sensor or output a control signal to the external load.

35. The battery management system (100) according to claim 34, wherein the high-voltage management chip (20) further comprises:
a first temperature detection circuit (27), the first temperature detection circuit (27) being connected to an external temperature sensor through the second general-purpose input/output interface circuit (26), to detect temperature information of the high-voltage management chip (20); and
a first temperature diagnosis circuit (28), the first temperature diagnosis circuit (28) being connected to the first temperature detection circuit (27) and configured to identify whether there is overtemperature in the high-voltage management chip (20) according to the temperature information of the high-voltage management chip (20) and perform overtemperature protection when there is overtemperature in the high-voltage management chip (20).

36. The battery management system (100) according to any one of claims 1 to 35, wherein the processor chip (40) is further configured to send configuration information of the high-voltage management chip (20) to the high-voltage management chip (20) through the dedicated integrated chip (30), and obtain at least one of detection information, computing result information, safety diagnosis information, and safety alarm information of the high-voltage management chip (20) through the dedicated integrated chip (30).

37. The battery management system (100) according to claim 17, wherein the high-voltage management chip (20) comprises:
a third daisy-chain serial peripheral interface circuit (201), the high-voltage management chip (20) being connected to the second daisy-chain serial peripheral interface circuit (303) of the dedicated integrated chip (30) through the third daisy-chain serial peripheral interface circuit (201).

38. The battery management system (100) according to any one of claims 1 to 37, wherein the high-voltage management chip (20) comprises at least one of the second standard serial peripheral interface circuit (304) and a second I2C bus interface circuit, and the at least one of the second standard serial peripheral interface circuit (304) and the second I2C bus interface circuit is a standby interface circuit.

39. The battery management system (100) according to any one of claims 1 to 38, wherein the high-voltage management chip (20) comprises:
a second controller area network bus interface circuit (202), the second controller area network bus interface circuit (202) being configured to connect to an external communication bus to obtain external bus information.

40. The battery management system (100) according to any one of claims 1 to 39, wherein the analog front-end chip (10) comprises:
a second detection circuit (11), the second detection circuit (11) being connected to the battery group and configured to detect the status parameter information of the battery cell in the battery group.

41. The battery management system (100) according to claim 40, wherein the analog front-end chip (10) further comprises:
a second analog input interface circuit (12), the second detection circuit (11) being connected to an external detection circuit through the second analog input interface circuit (12), to detect the status parameter information of the battery cell in the battery group.

42. The battery management system (100) according to claim 40 or 41, wherein the analog front-end chip (10) further comprises:
a third general-purpose input/output interface circuit (13), the third general-purpose input/output interface circuit (13) being connected to an external sensor, and the second detection circuit (11) being connected to the external sensor through the third general-purpose input/output interface circuit (13), to detect the status parameter information of the battery cell in the battery group.

43. The battery management system (100) according to claim 40, wherein the second detection circuit (11) comprises:
a second voltage detection circuit (111), the second voltage detection circuit (111) being configured to collect voltage information of the battery cell in the battery group.

44. The battery management system (100) according to claim 43, wherein the second detection circuit (11) further comprises:
a second current detection circuit (112), the second current detection circuit (112) being configured to collect current information of the battery cell in the battery group.

45. The battery management system (100) according to claim 44, wherein the second detection circuit (11) further comprises:
a stress detection circuit (113), the stress detection circuit (113) being configured to detect stress information of the battery cell in the battery group.

46. The battery management system (100) according to claim 45, wherein the second detection circuit (11) further comprises:
a second temperature detection circuit (114), the second temperature detection circuit (114) being configured to detect temperature information of the battery cell in the battery group.

47. The battery management system (100) according to claim 46, wherein the front-end analog chip (10) further comprises:
a second safety diagnosis circuit (14), the second safety diagnosis circuit (14) being connected to the second detection circuit (11) and configured to identify whether the status parameter information of the battery cell is abnormal and perform safety protection when the status parameter information of the battery cell is abnormal.

48. The battery management system (100) according to claim 47, wherein the second safety diagnosis circuit (14) comprises:
a second voltage diagnosis circuit (141), the second voltage diagnosis circuit (141) being connected to the second voltage detection circuit (111) and configured to identify whether there is overvoltage or undervoltage for a voltage of the battery cell in the battery group and perform overvoltage or undervoltage protection when there is overvoltage or undervoltage for the voltage of the battery cell.

49. The battery management system (100) according to claim 48, wherein the second voltage detection circuit (111) is further configured to detect a voltage of the battery group and voltages of internal components of the analog front-end chip (10); and
the second voltage diagnosis circuit (141) is further configured to identify whether the voltage of the battery group is abnormal and identify whether the voltages of the internal components of the analog front-end chip (10) are abnormal, and perform voltage safety protection when an exception occurs.

50. The battery management system (100) according to any one of claims 47 to 49, wherein the second safety diagnosis circuit (14) comprises:
a second current diagnosis circuit (142), the second current diagnosis circuit (142) being connected to the second current detection circuit (112) and configured to identify whether there is overcurrent for a current of the battery cell and perform overcurrent protection when there is overcurrent for the current of the battery cell.

51. The battery management system (100) according to claim 50, wherein
the second current detection circuit (112) is further configured to detect a current of the battery group and currents of the internal components of the analog front-end chip (10); and
the second current diagnosis circuit (142) is further configured to diagnose whether the current of the battery group is abnormal and identify whether the currents of the internal components of the analog front-end chip (10) are abnormal, and perform current abnormality safety protection when there is an abnormal current.

52. The battery management system (100) according to any one of claims 47 to 51, wherein the second safety diagnosis circuit (14) comprises:
a stress diagnosis circuit (143), the stress diagnosis circuit (143) being configured to identify whether a stress of the battery cell in the battery group is abnormal and perform stress abnormality safety protection when the stress is abnormal.

53. The battery management system (100) according to any one of claims 47 to 52, wherein the second safety diagnosis circuit (14) comprises:
a second temperature diagnosis circuit (144), the second temperature diagnosis circuit (144) being connected to the second temperature detection circuit (114) and configured to identify whether there is overtemperature for a temperature of the battery cell in the battery group and perform overtemperature safety protection when there is overtemperature for the temperature of the battery cell.

54. The battery management system (100) according to any one of claims 47 to 53, wherein the analog front-end chip (10) further comprises:
a second digital logic circuit (15), the second digital logic circuit (15) being connected to the second safety diagnosis circuit (14) and configured to generate exception information when the status parameter information of the battery cell in the battery group is abnormal, to give an alarm prompt.

55. The battery management system (100) according to claim 54, wherein the processor chip (40) is further configured to send configuration information of the analog front-end chip (10) to the analog front-end chip (10) through the dedicated integrated chip (30), and obtain at least one of detection information, safety diagnosis information, safety alarm information, and computing result information of the analog front-end chip (10) through the dedicated integrated chip (30).

56. The battery management system (100) according to any one of claims 1 to 55, wherein
that the processor chip (40) is configured to manage the battery management system (100) according to the status parameter information of the battery cell and the status parameter information of the battery pack (200) comprises: the processor chip (40) is configured to generate power equalization information when it is determined, according to the status parameter information of the battery cell in the battery group, that the power of the battery cell in the battery group is unbalanced, and forward the power equalization information to the corresponding front-end analog chip through the dedicated integrated chip (30); and
the analog front-end chip (10) comprises an equalization circuit (16), the equalization circuit (16) being configured to perform power equalization processing on the battery cell in the battery group according to the power equalization information.

57. The battery management system (100) according to any one of claims 1 to 56, wherein
that the processor chip (40) is configured to manage the battery management system (100) according to the status parameter information of the battery cell and the status parameter information of the battery pack (200) comprises: the processor chip (40) is configured to determine a battery state according to the status parameter information of the battery cell and the status parameter information of the battery pack (200), and determine, according to the battery state, whether to charge or discharge the battery pack (200) and whether to stop charging or discharging the battery pack (200).

58. The battery management system (100) according to any one of claims 1 to 57, wherein that the processor chip (40) is configured to manage the battery management system (100) according to the status parameter information of the battery cell and the status parameter information of the battery pack (200) comprises: the processor chip (40) is configured to estimate a state-of-charge value of the battery pack (200) according to the status parameter information of the battery cell and/or the status parameter information of the battery pack (200), obtain a state-of-charge value of the battery pack (200) estimated by the high-voltage management chip (20), and perform battery state verification according to the state-of-charge value of the battery pack (200) estimated by the processor chip (40) and the state-of-charge value of the battery pack (200) estimated by the high-voltage management chip (20).

59. The battery management system (100) according to claim 14, wherein there are a plurality of analog front-end chips (10), and the plurality of analog front-end chips (10) are connected in series.

60. The battery management system (100) according to claim 59, wherein
there are two first daisy-chain serial peripheral interface circuits (301);
each analog front-end chip (10) comprises a fourth daisy-chain serial peripheral interface circuit and a fifth daisy-chain serial peripheral interface circuit; and
in the plurality of analog front-end chips (10) connected in series, a head-end analog front-end chip (10) is connected to one first daisy-chain serial peripheral interface circuit (301) of the dedicated integrated chip (30) through the fourth daisy-chain serial peripheral interface circuit, and a tail-end analog front-end chip (10) is connected to the other first daisy-chain serial peripheral interface circuit (301) of the dedicated integrated chip (30) through the fifth daisy-chain serial peripheral interface circuit.

61. The battery management system (100) according to claim 60, wherein in the plurality of analog front-end chips (10) connected in series, an n^{th} analog front-end chip (10) is connected to the fourth daisy-chain serial peripheral interface circuit of an (n+1)^{th} analog front-end chip (10) through the fifth daisy-chain serial peripheral interface circuit, 1 ≤ n < n+1 < N, and N is a total quantity of the plurality of analog front-end chips (10) connected in series.

62. The battery management system (100) according to any one of claims 1 to 61, wherein the analog front-end chip (10) comprises at least one of a third standard serial peripheral interface circuit and a third I2C bus interface circuit, and the at least one of the third standard serial peripheral interface circuit and the third I2C bus interface circuit is a standby interface circuit.

63. A battery (2), comprising:
a battery pack (200), the battery pack (200) comprising a plurality of battery groups, and each battery group comprising at least one battery cell; and
the battery pack (200) being connected to the battery management system (100) according to any one of claims 1 to 62, and each battery group being connected to the battery management system (100).

64. A vehicle (1), comprising:
a battery pack (200), the battery pack (200) comprising a plurality of battery groups, and each battery group comprising at least one battery cell; and
the battery management system (100) according to any one of claims 1 to 62, the battery management system (100) being connected to the battery pack (200).

65. A battery management method, wherein the battery management method is applicable to the battery management system (100) according to any one of claims 1 to 62, and the battery management method comprises:
detecting, by a high-voltage management chip, status parameter information of a battery pack, and detecting, by an analog front-end chip, status parameter information of a battery cell in a battery group, the battery pack comprising a plurality of battery groups, and the battery group comprising at least one battery cell;
forwarding, by a dedicated integrated chip, the status parameter information of the battery pack and the status parameter information of the battery cell in the battery group to a processor chip; and
managing, by the processor chip, the battery management system according to the status parameter information of the battery cell and the status parameter information of the battery pack.

66. The battery management method according to claim 65, wherein managing, by the processor chip, the battery management system according to the status parameter information of the battery cell and the status parameter information of the battery pack comprises:
estimating, by the processor chip, a state-of-charge value and/or a state-of-health value of the battery pack according to voltage information and current information of the battery cell and/or voltage information and current information of the battery pack.

67. The battery management method according to claim 66, wherein managing, by the processor chip, the battery management system according to the status parameter information of the battery cell and the status parameter information of the battery pack further comprises:
determining, by the processor chip according to a state of charge of the battery pack, whether to charge or discharge the battery pack and whether to stop charging or discharging the battery pack.

68. The battery management method according to any one of claims 65 to 67, wherein managing, by the processor chip, the battery management system according to the status parameter information of the battery cell and the status parameter information of the battery pack comprises:
determining, by the processor chip according to the status parameter information of the battery cell in the battery group, that the power of the battery cell in the battery group is unbalanced, generating power equalization information, and forwarding the power equalization information to the front-end analog chip through the dedicated integrated chip.

69. The battery management method according to any one of claims 65 to 68, wherein the battery management method further comprises:
generating, by the processor chip, power supply configuration information according to a power supply requirement of an internal electric chip of the battery management system, and sending the power supply configuration information to the dedicated integrated chip, to manage the battery management system in providing an operating power supply for the internal electric chip.

70. The battery management method according to any one of claims 65 to 69, wherein the battery management method further comprises:
generating, by the processor chip, a power switch channel selection control signal according to an electric power demand of an external electric unit, and sending the power switch channel selection control signal to the dedicated integrated chip, to manage the battery management system in connecting or disconnecting power supply for the external electric unit; and
controlling, by the dedicated integrated chip according to the power switch channel selection control signal, connection/disconnection between the external electric unit connected to the power supply circuit and a power supply side, or controlling connection/disconnection between the external electric unit and a power supply ground side.

71. The battery management method according to any one of claims 65 to 70, wherein the battery management method further comprises:
sending, by the processor chip, configuration information of the dedicated integrated chip to the dedicated integrated chip, and obtaining interface circuit transfer information of the dedicated integrated chip; and
obtaining, by the processor chip, at least one of safety monitoring information, safety alarm information, and operating status information of the dedicated integrated chip.

72. The battery management method according to any one of claims 65 to 71, wherein the battery management method further comprises:
sending, by the processor chip, configuration information of the high-voltage management chip to the high-voltage management chip through the dedicated integrated chip, and obtaining detection information of the high-voltage management chip through the dedicated integrated chip; and
obtaining, by the processor chip, at least one of computing result information, safety diagnosis information, and safety alarm information of the high-voltage management chip through the dedicated integrated chip.

73. The battery management method according to any one of claims 65 to 72, wherein the battery management method further comprises:
sending, by the processor chip, configuration information of the analog front-end chip to the analog front-end chip through the dedicated integrated chip, and obtaining detection information of the analog front-end chip through the dedicated integrated chip; and
obtaining, by the processor chip, at least one of safety diagnosis information, safety alarm information, and computing result information of the analog front-end chip through the dedicated integrated chip.

74. The battery management method according to claim 69, wherein the battery management method further comprises:
controlling, by the dedicated integrated chip according to the power supply configuration information, a power supply circuit of the dedicated integrated chip to provide an operating power supply for at least one of internal electric chips of the battery management system.

75. The battery management method according to claim 66, wherein the status parameter information of the battery pack comprises the voltage information and the current information of the battery pack, and the battery management method further comprises:
estimating, by the high-voltage management chip, a state-of-charge value and/or a state-of-health value of the battery pack according to the voltage information and the current information of the battery pack.

76. The battery management method according to claim 75, wherein managing, by the processor chip, the battery management system according to the status parameter information of the battery cell and the status parameter information of the battery pack further comprises:
obtaining, by the processor chip through the dedicated integrated chip, the state-of-charge value of the battery pack estimated by the high-voltage management chip, and verifying a status of the battery pack according to the state-of-charge value of the battery pack estimated by the processor chip and the state-of-charge value of the battery pack estimated by the high-voltage management chip.

77. The battery management method according to any one of claims 65 to 76, wherein the status parameter information of the battery pack comprises resistance between a power cord of the battery pack and an insulation ground of a vehicle body, and the battery management method further comprises:
determining, by the high-voltage management chip, a status of current leakage of the battery pack according to the resistance.

78. The battery management method according to claim 72, wherein the battery management method further comprises:
identifying, by the high-voltage management chip, whether the status parameter information of the battery pack is abnormal, and performing safety protection when the status parameter information of the battery pack is abnormal.

79. The battery management method according to claim 78, wherein identifying, by the high-voltage management chip, whether the status parameter information of the battery pack is abnormal, and performing safety protection when the status parameter information of the battery pack is abnormal comprises at least one of the following:
identifying, by the high-voltage management chip according to the current information of the battery pack, whether there is overcurrent in the battery pack, and performing overcurrent protection when there is overcurrent in the battery pack; and
identifying, by the high-voltage management chip according to the voltage information of the battery pack, whether there is overvoltage or undervoltage in the battery pack, and performing overvoltage or undervoltage protection when there is overvoltage or undervoltage in the battery pack.

80. The battery management method according to claim 79, wherein the battery management method further comprises:
obtaining, by the high-voltage management chip, temperature information of the high-voltage management chip; and
identifying, by the high-voltage management chip according to the temperature information of the high-voltage management chip, whether there is overtemperature in the high-voltage management chip, and performing overtemperature protection when there is overtemperature in the high-voltage management chip.

81. The battery management method according to any one of claims 73 to 76, wherein the battery management method further comprises:
identifying, by the analog front-end chip, whether the status parameter information of the battery cell is abnormal, and performing safety protection when the status parameter information of the battery cell is abnormal.

82. The battery management method according to claim 81, wherein identifying, by the analog front-end chip, whether the status parameter information of the battery cell is abnormal, and performing safety protection when the status parameter information of the battery cell is abnormal comprises at least one of the following:
identifying, by the analog front-end chip, whether there is overvoltage or undervoltage for a voltage of the battery cell in the battery group, and performing overvoltage or undervoltage protection when there is overvoltage or undervoltage for the voltage of the battery cell;
identifying, by the analog front-end chip, whether there is overcurrent for a current of the battery cell, and performing overcurrent protection when there is overcurrent for the current of the battery cell;
identifying, by the analog front-end chip, whether a stress of the battery cell in the battery group is abnormal, and performing safety protection when the stress is abnormal; and
identifying, by the analog front-end chip, whether there is overtemperature for a temperature of the battery cell in the battery group, and performing overtemperature safety protection when there is overtemperature for the temperature of the battery cell.

83. The battery management method according to claim 82, wherein the battery management method further comprises at least one of the following:
identifying, by the analog front-end chip, whether a voltage of the battery group is abnormal, identifying whether voltages of internal components of the analog front-end chip are abnormal, and performing voltage safety protection when an exception occurs; and
diagnosing, by the analog front-end chip, whether a current of the battery group is abnormal, identifying whether currents of the internal components of the analog front-end chip are abnormal, and performing current protection when there is an abnormal current.
